(19) Europäisches Patentamt / European Patent Office / Office européen des brevets

(11) **EP 3 616 131 B1**

(12) **FASCICULE DE BREVET EUROPEEN**

(45) Date de publication et mention de la délivrance du brevet:
**10.07.2024 Bulletin 2024/28**

(21) Numéro de dépôt: **18718861.0**

(22) Date de dépôt: **27.04.2018**

(51) Classification Internationale des Brevets (IPC):
**G06N 3/044** (2023.01)    **G06N 3/063** (2023.01)

(52) Classification Coopérative des Brevets (CPC):
**G06N 3/044; G06N 3/063**

(86) Numéro de dépôt international:
**PCT/EP2018/060923**

(87) Numéro de publication internationale:
**WO 2018/197689 (01.11.2018 Gazette 2018/44)**

(54) **PROCÉDÉ ET DISPOSITIF ASSOCIÉ AUTOMATISÉS APTES À MÉMORISER, RAPPELER ET GÉRER DE MANIÈRE NON VOLATILE DES ASSOCIATIONS DE MESSAGES VERSUS LABEL ET VICE VERSA, AVEC UN MAXIMUM DE VRAISEMBLANCE**

AUTOMATISIERTES VERFAHREN UND ZUGEHÖRIGE VORRICHTUNG ZUM NICHTFLÜCHTIGEN SPEICHERN, ABRUFEN UND VERWALTEN VON NACHRICHTEN-/KENNZEICHENZUORDNUNGEN UND UMGEKEHRT MIT MAXIMALER WAHRSCHEINLICHKEIT

AUTOMATED METHOD AND ASSOCIATED DEVICE FOR THE NON-VOLATILE STORAGE, RETRIEVAL AND MANAGEMENT OF MESSAGE/LABEL ASSOCIATIONS AND VICE VERSA, WITH MAXIMUM LIKELIHOOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.04.2017 FR 1700463**

(43) Date de publication de la demande:
**04.03.2020 Bulletin 2020/10**

(73) Titulaire: **ANOTHER BRAIN**
**75002 Paris (FR)**

(72) Inventeur: **PIRIM, Patrick**
**75013 Paris (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**WO-A1-2014/203039    US-A1- 2007 239 644**

• **GRIPON VINCENT ET AL: "Maximum likelihood associative memories", 2013 IEEE INFORMATION THEORY WORKSHOP (ITW), IEEE, 9 September 2013 (2013-09-09), pages 1 - 5, XP032536329, ISBN: 978-1-4799-1321-3, [retrieved on 20131220], DOI: 10.1109/ITW.2013.6691310**
• **PIRIM PATRICK ED - WALTER DIDIMO ET AL: "Perceptive Invariance and Associative Memory Between Perception and Semantic Representation USER a Universal SEmantic Representation Implemented in a System on Chip (SoC)", 12 July 2016, MEDICAL IMAGE COMPUTING AND COMPUTER-ASSISTED INTERVENTION - MICCAI 2015 : 18TH INTERNATIONAL CONFERENCE, MUNICH, GERMANY, OCTOBER 5-9, 2015; PROCEEDINGS; [LECTURE NOTES IN COMPUTER SCIENCE; LECT.NOTES COMPUTER], SPRINGER INTERNATIONAL PUBLISHING, CH, ISBN: 978-3-642-38287-1, ISSN: 0302-9743, XP047350737**

• K. PAGIAMTZIS ET AL: "Content-Addressable Memory (CAM) Circuits and Architectures: A Tutorial and Survey", IEEE JOURNAL OF SOLID-STATE CIRCUITS, vol. 41, no. 3, 1 March 2006 (2006-03-01), pages 712 - 727, XP055065930, ISSN: 0018-9200, DOI: 10.1109/JSSC.2005.864128
• PAGIAMTZIS K ET AL: "A Low-Power Content-Addressable Memory (CAM) Using Pipelined Hierarchical Search Scheme", IEEE JOURNAL OF SOLID-STATE CIRCUITS, IEEE SERVICE CENTER, PISCATAWAY, NJ, USA, vol. 39, no. 9, 1 September 2004 (2004-09-01), pages 1512 - 1519, XP011117971, ISSN: 0018-9200, DOI: 10.1109/JSSC.2004.831433
• PATRICK PIRIM ED - NATHAN F LEPORA ET AL: "Generic Bio-inspired Chip Model-Based on Spatio-temporal Histogram Computation: Application to Car Driving by Gaze-Like Control", 29 July 2013, BIOMIMETIC AND BIOHYBRID SYSTEMS, SPRINGER BERLIN HEIDELBERG, BERLIN, HEIDELBERG, PAGE(S) 228 - 239, ISBN: 978-3-642-39801-8, XP047034251

**Description**

**Domaine de l'invention**

La présente invention concerne un procédé ainsi qu'un dispositif automatisé apte à mémoriser, rappeler et, gérer de manière non volatile, des associations de messages versus labels et vice versa, avec un maximum de vraisemblance. Elle concerne également un système de mémorisation des apprentissages de réseaux de populations neuronales.

L'invention s'applique notamment pour l'implémentation de réseaux de neurones sur silicium pour le traitement de signaux divers, y compris des signaux multidimensionnels comme la représentation de perception d'images, de son ou d'autres modalités perçues indépendamment ou simultanément par exemple. Plus généralement, l'invention permet la réalisation efficace sur silicium d'une chaine complète du traitement du signal par l'approche bio-inspiré de réseaux de populations neuronales. Elle permet aussi la réalisation efficace de méthodes de traitement du signal conventionnelles, utile par exemple en prétraitement avant le traitement neuronal et/ou en post-traitement.

**Etat de la technique**

La mémoire de l'être humain est fondamentalement associative : on retient mieux lorsqu'on peut relier la nouvelle information à des connaissances déjà acquises et solidement ancrées dans notre mémoire. Et ce lien sera d'autant plus efficace qu'il a une signification pour nous. Plutôt que la simple évocation de traces fixes, la mémoire est donc aujourd'hui considérée comme un processus continuel de ré-catégorisation découlant d'un changement continu des voies antagonistes neuronales et du traitement en parallèle de l'information dans le cerveau.

La technique tente de copier ces processus en utilisant principalement le procédé électronique appelé mémoire associative ou mémoire adressable par contenu (*CAM, en anglais Content-Addressable Memory*). Un état des développements en a été fait dans la publication de K. Pagiamtzis et A. Sheikholeslami, « Content-addressable memory (CAM) circuits and architectures : A tutorial and survey » IEEE Journal of Solid-State Circuits, vol. 41, no. 3, pp. 712-727, Mar 2006.

Cette mémorisation est devenue non volatile avec l'apparition des mémoires MRAM *(Magnetic Random Access Memory)* où les données sont stockées sous forme d'une orientation magnétique. Le changement d'état se fait en changeant le spin des électrons (par effet tunnel notamment). Ces composants sont commercialisés par la société Everspin entre autres.

En France, une technologie MRAM a été codéveloppée par le laboratoire Spintec du CNRS et la société Crocus Technology à Grenoble. Elle repose sur une technique de programmation innovante qui permet de s'affranchir des limitations en stabilité et en réduction de taille. À la place du traditionnel empilement de couches ferromagnétiques, les partenaires ont développé un point mémoire qui associe une couche ferromagnétique à une couche antiferromagnétique plus stable avec la température. S'ajoute à cela une technique de cellule mémoire autoréférencée qui permet d'intégrer directement dans le plan mémoire une fonction de comparaison logique nommée Match-In-Place. Le brevet US9 401 208 82 « *Magnetic random access memory cell with a dual jonction for ternary content addressable memory applications* » de cette même société décrit l'intégration d'un mode ternaire : Le CAM ternaire permet un troisième état de correspondance appelé "X" ou "quelconque" pour un ou plusieurs bits dans le mot de donnée stocké, permettant l'ajout de flexibilité dans la recherche. Par exemple, un CAM ternaire pourrait avoir un mot stocké de "10XX0" qui correspondra aux recherches des mots "10000", "10010", "10100", ou "10110".

Cette cellule mémoire est du type STT-MRAM *(pour en anglais, spin transfert torque magnefic RAM)*. Son dimensionnement permet une intégration à grande échelle et faible cout avec une consommation très réduite et la garantie d'une très longue rétention de l'information.

Un autre procédé de mémoire non volatile émerge actuellement, appelé NRAM pour Nano-RAM, qui est le fruit des recherches menées par Nantero, une firme américaine. Elle utilise les caractéristiques des nanotubes de carbones qui permettent de réduire considérablement la taille d'une puce et donc d'accroître la capacité d'un module. Ce procédé mémoire est décrit dans le brevet n° US 9 299 430 B1 « Method for reading and programming 1-R resistive charge element arrays » de cette compagnie.

Chaque cellule est composée d'un certain nombre de nanotubes suspendus au-dessus d'une électrode. Lorsqu'un courant passe entre les deux électrodes, les nanotubes se trouvent attirés vers l'électrode supérieure pour venir rentrer en contact. Dans le cas où il n'y a pas de courant entre les deux électrodes, les nanotubes de carbone restent suspendus dans les airs. Pour savoir si les nanotubes touchent ou non l'électrode supérieure, une tension est envoyée entre le terminal et l'électrode supérieure. Si le courant passe, cela signifie que les nanotubes sont en contact avec l'électrode supérieure et l'on renvoie la valeur 1. Si le courant ne passe pas, les nanotubes sont suspendus et l'on renvoie la valeur 0. Les valeurs 0 et 1 sont donc des positions dites stables, car il n'y a aucune tension mécanique sur les nanotubes. Cette architecture est plus favorable à l'augmentation de la finesse de gravure que celle de la DRAM et demande moins de courant pour l'écriture de données tout en ayant des vitesses similaires à la SRAM.

Une autre technique de mémoire non volatile basée sur un procédé ferroélectrique de l'oxyde d'hafnium décrit dans le brevet US7,709,359 est très prometteuse par une taille de cellule réduite, environ 10F$^2$, une consommation en mode écriture au moins 1000 fois inférieure à la STT-MRAM, et une compatibilité de fabrication avec la technologie CMOS, aussi bien en échelle de gravure qu'en compatibilité de processus.

Ces technologies ont donné lieu à plusieurs développements publiés dans le domaine des sciences neuronales dont celle de :

- V. Gripon and C. Berrou, "Sparse neural networks with large learning diversity," IEEE trans. on Neural Networks, vol. 22, n 7, pp. 1087-1096, July 2011. Cet article donne une définition de :

   ∘ la diversité d'apprentissage grâce à la parcimonie (en tant que traduction de l'anglais *sparsity*) de l'information à partir d'une quantité d'informations mémorisées M, dans la description qui suit : égale à $2^v$ avec une quantité de codes correspondant au sous-message $I=2^w$, le message k étant constitué de c sous-messages (dans la description qui suit : un message ME constitué de n sous-messages). La longueur du message ME est donc de n fois w bits et la diversité de mémorisation est de $2^{n+w}$.
   ∘ La densité d qui, pour une valeur de M >>c (ici $2^v$ >> n~8) et M<< $I^2$ (ici $2^v$ << $2^{n+w}$) est proche de $M/I^2$ soit dans la description qui suit :

$$d= 2^v/2^{2+w} \text{ ou } 2^{v-(2+w)}.$$

Cette densité se doit d'être faible afin d'éviter la confusion des messages appris correspondant au taux d'erreurs admissibles, avec les valeurs de v=16 et w=24, $d=2^{-10}$ soit un taux d'erreurs proche de 0,001.

Associé à cet article, les auteurs ont déposés deux brevets : FR2964222A1 et FR2980876A1 décrivant un dispositif neuronal utilisant ces principes.

- Hooman Jarollahi, Vincent Gripon, Naoya Onizawa, and Warren J. Gross « A low-power Content-Addressable Memory based on clustered-sparse networks » ASAP, 2013 IEEE 24th int. conférence.
- F. Leduc-Primeau, V. Gripon, M. G. Rabbat, and W. J. Gross, "Clusterbased associative memories built from unreliable storage," in Proc. Of IEEE Intl. Conf. on Acoustics, Speech, and Signal Processing (ICASSP), May 2014.
- Demetrio Ferro, Vincent Gripon, Xiaoran Jiang, "Nearest Neighbour Search Using Binary Neural Networks" International Joint Conférence on Neural Networks (IJCNN) 2016.
- Qing Guo, Xiaochen Guo, Yuxin Bai, Engin_Ipek, "A Resistive TCAM Accelerator for Data-Intensive Computing "MICRO'11 December 3-7, 2011, Porto Alegre, Brazil et,
- Qing Guo, Xiaochen Guo, Ravi Patel, Engin_Ipek, Eby G. Friedman "AC-DIMM: Associative Computing with STT-MRAM', ISCA '2013 Tel-Aviv, Israel, ont introduit ces mécanismes de mémoire associative dans un composant électronique agencé en tant que barrette mémoire au format DIMM en remplacement de celles existantes, donc en utilisant l'organisation des bus existants.

Toutes ces approches de mémorisation par association ne permettent pas un fonctionnement concomitant dans les deux sens *(bottom up and top-down)* existant dans le vivant et permettant le bouclage dynamique de l'information. D'autre part, les éléments mémorisés ne sont pas transférables simplement d'un support à un autre support.

Une autre approche a été abordée par P. Pirim, auteur de cette présente invention, dans le but de pallier ces inconvénients dans une publication : "Perceptive Invariance and Associative Memory Between Perception and Semantic Représentation, USER a Universal Semantic Représentation Implemented in a System on Chip (SoC)" publié dans Living Machines 2016, LNAI 9793, pp. 275-287, 2016. Cette première approche succincte, a été suivie de nombreuses améliorations décrites dans cette invention. Un nouveau modèle de la mémoire associative a été créé en intégrant les nouvelles techniques TCAM permettant la correction d'erreur par un calcul de maximum de vraisemblance dans une grande intégration à cout réduit.

**Objectif de l'invention**

L'invention concerne donc un procédé ainsi qu'un dispositif automatisé apte à mémoriser, rappeler et, gérer de manière non volatile, des associations, avec un maximum de vraisemblance, de messages versus labels et inversement, appelé « Mémorisation Associative » dans la suite du texte.

Ce Procédé de Mémorisation Associative est défini par la revendication 15. En particulier, le procédé utilise un assemblage de au moins deux sous-unités mémoires similaires à accès par contenu de $2^v$ mots de w bits pour la première, avec v compris entre 1 et w et, de $2^v$ mots de v bits pour la seconde.

La sous-unité Mémoire Associative est programmée en mode écriture par,

- un port d'adresses en mode entrée de v bits,
- un port de données en mode entrée de v ou w bits et
- un port de commande comportant, une horloge entrée binaire de séquencement et deux signaux entrées binaires, l'un de sélection de la mémoire et l'autre d'écriture, ces deux signaux étant validés dans cette séquence d'écriture, permettant, pendant ce cycle, l'enregistrement du mot de v ou w bits présent sur le port de données à la position mémoire adressée par le mot de de v bits sur le port d'adresses,

et cette même sous-unité Mémoire Associative est programmée en mode lecture par,

- un port de commande comportant, une horloge entrée binaire de séquencement, deux signaux entrées binaires, l'un de sélection de la mémoire valide, et l'autre d'écriture non valide dans cette séquence de lecture et un signal de sortie binaire de validation du contenu présent selon l'invention dans ce mode lecture :

  - l'on réalise une lecture, sur un port de sortie des données, d'une donnée de v ou w bits, précédemment enregistrées en mode écriture, sélectionnée par un mot de v bits présenté sur le port d'adresses entrée et indépendamment,
  - l'on réalise une lecture, sur un port de sortie d'adresses de contenu mémoire, d'une donnée de v bits, correspondant à l'adresse de la donnée de v ou w bits présentée sur le port de données entrée, si précédemment cette donnée de v ou w bits a été enregistrée en mode écriture à au moins une position mémoire, en validant le signal binaire de sortie de validation du contenu présent. Dans le cas contraire où aucune des $2^v$ positions mémoires contiennent la donnée de v ou w bits présentée sur le port de données entrée, la sortie non valide du port de sortie d'adresses de contenu mémoire est signalée par la non validation du signal binaire de sortie de validation du contenu présent.

Dans divers modes de mise en oeuvre de l'invention, les moyens suivants sont employés :

- l'unité Mémorisation Associative sélectionnée en mode lecture, (Wr = 0), l'on associe au moins deux sous-unités mémoires similaires par deux bus indépendant de v bits :

  - le premier bus, connecté entre le port de sortie d'adresses de contenu mémoire de v bits de la première mémoire associative et le port d'adresses en mode entrée de v bits de la seconde mémoire associative et,
  - le second bus, connecté entre le port de sortie d'adresses de contenu mémoire de v bits de la seconde mémoire associative et le port d'adresses en mode entrée de v bits de la première mémoire associative.

- l'unité Mémorisation Associative sélectionnée en mode écriture, l'on associe au moins deux sous-unités mémoires similaires, par un bus commun de v bits, issu de la sortie d'un compteur binaire de v bits, et connecté au port d'adresses en mode entrée de v bits de chaque mémoire associative.
- l'unité Mémorisation Associative possède une phase d'initialisation, impliquant l'ensemble des sous-unités mémoires présentes, commandée par une unité d'initialisation des sous-unités mémoires qui est déclenché par la validation des signaux binaires entrées d'initialisation et de sélection de l'ensemble des mémoires issu du port de commande. Cet unité d'initialisation initialise à zéro le compteur binaire de v bits, puis l'incrémente d'une unité à chaque cycle d'horloge entrée binaire de séquencement pendant $2^v +1$ cycles. Durant ce laps de temps l'unité d'initialisation valide le mode écriture, (signal entrée binaire d'écriture validé), et le forçage à zéro du port entrée des données (In) de chacune des sous unités mémoires. En fin de séquence, toutes les positions mémoires de chacune des sous-unités mémoires sont initialisées à zéro ainsi que le compteur binaire de v bits,
- en dehors de la séquence d'initialisation, le signal entrée binaire de sélection de la mémoire étant validé, l'on incrémente le compteur binaire (3) de v bits d'une valeur unitaire en début de chaque validation du signal d'écriture mémoire,
- on valide un signal de limite de comptage lorsque la valeur du compteur binaire de v bits atteint la valeur $2^v -1$,
- programmée en mode lecture, l'on regroupe les sous-unités mémoires en deux ensembles, le premier intégrant n sous-unités mémoires comprenant chacune $2^v$ mots de w bits, le second représenté par une sous-unité Mémoire Associative comprenant $2^v$ mots de v bits, ces deux ensembles étant liés par deux bus antagonistes :

  - le premier bus, issu du port de sortie d'adresses de contenu mémoire de v bits de la sous-unité Mémoire Associative comprenant $2^v$ mots de v bits, est connecté sur le port d'adresses en mode entrée de v bits de chacune des n sous-unités mémoires.

- Le second bus, constitué de la sortie de chacun des ports de sorties d'adresses de contenu mémoire de v bits et de leurs signaux de sortie binaire de validation de contenu respectif présent dans l'ensemble des n sous-unités mémoires, est introduit dans une unité de sélection du maximum de vraisemblance des valeurs d'entrées qui fournit en sortie la valeur sélectionnée la plus représentée. Cette valeur du maximum de vraisemblance est introduite dans le port d'adresses en mode entrée de v bits de la sous-unité Mémoire Associative comprenant $2^v$ mots de v bits.

- par validation d'un signal entrée binaire de correction en mode lecture, l'on transmette les informations de la sortie de l'unité de valeur du maximum de vraisemblance vers le premier bus précédemment décrit

- programmée en mode écriture, la valeur du compteur binaire de v bits soit incrémentée d'une unité en début du cycle d'écriture afin de fournir une valeur correspondante à la nouvelle adresse sur un bus relié à tous les ports d'adresses en mode entrée de v bits de chaque sous-unité Mémoire Associative regroupées en deux ensembles, le premier intégrant n mémoires associatives comprenant chacune $2^v$ mots de w bits, le second représenté par une sous-unité Mémoire Associative comprenant $2^v$ mots de v bits.

- le regroupement de ces deux ensembles de sous-unités mémoires incluant le compteur binaire de v bits, l'unité de calcul du maximum de vraisemblance, l'unité d'initialisation, et les divers éléments logiques de contrôle constitue l'unité de base de la Mémorisation Associative.

- en mode lecture, l'on associe l'unité Mémorisation Associative à un message (MEin_i) constitué de n sous-messages(RSin_1 à RSin_n) indépendant de w bits en entrée à un label (Lout_j) de v bits en sortie et, vice versa en entrée un label (Lin_i) de v bits associe en sortie un message (MEout_j) constitué de n sous-messages (RSout_1 à RSout_n) indépendant de w bits: la présence d'un message (MEin_i) même partiel présenté à l'unité de base de la mémoire associative (10) fourni en sortie un label (Lout_i), en retour, ce label devient (Lin_i) et, étant connecté en entrée à l'unité Mémorisation Associative (10), délivre le message (MEout_i) complet correspondant précédemment appris.

- on structure chaque sous-messages indépendant entrant (RSin_x) et sortant (RSout_x) de w bits chacun en p éléments de w/p bits avec, pour chaque élément, une définition propre à son emplacement.

- chaque élément de w/p bits puisse être mis indépendamment si nécessaire en mode accès par contenu ternaire (TCAM).

- le sous-message (RSout_x) de w bits sortant de l'unité Mémoire Associative soit connecté à l'unité de registres d'entrée d'un attracteur dynamique et que l'unité de registres résultat de ce même attracteur dynamique délivre le sous-message entrant (RSin_x) de w bits de l'unité Mémoire Associative.

- les p éléments de w/p bits du sous-message indépendant entrant (RSin_x) et sortant (RSout_x) de w bits aient, comme définition propre à son emplacement, une représentation sémantique élémentaire de type globale, dynamique ou structurale.

- l'attracteur dynamique extrait, des flots de données séquencés à sous séquences issue d'une unité de conversion d'un flow de données entrant, une représentation sémantique élémentaire de type globale, dynamique, structurale et, référencée en position correspondant à un sous-message.

- par recrutement dynamique des attracteurs dynamiques avec inhibition des antécédents (chainage Cout de l'attracteur dynamique (80_x) à Cin de l'attracteur dynamique (80_x+1). Chaque attracteur dynamique en fonction définit un sous-message dont l'ensemble correspond au message transmis.

- les unités de bases Mémorisation Associative se connectent en mode pyramidal inverse, un premier niveau de p unités de base de Mémoire Associative reçoit p messages et génère p labels qui se connectent chacun en tant que sous-message d'une unités de base de Mémoire Associative en second niveau en générant un label récapitulatif des sous-messages entrant, et en inverse un second label récapitulatif entrant dans cette unité de base de mémoire associative génère un ensemble de sous-messages qui se connectent en tant que label associé à un sous-message à l'ensemble des p unités de base de mémoire associative du premier niveau et délivre un ensemble de p messages.

- on associe les sous-unités mémoires représentant l'unité de base Mémoire Associative en mode lecture par un bus commun de v bits, issu de la sortie d'un compteur binaire de v bits, et connecté au port d'adresses en mode entrée de v bits de chaque sous-unité Mémoire Associative, ce compteur binaire de v bits étant initialisé à zéro puis incrémenté d'une unité par la commande d'un signal binaire de transfert. A chaque séquence de transfert, la valeur du message (RSout_i) et de son label (Lout_i) associé sont accessibles.

- on assure le transfert de connaissance des Mémorisations Associatives acquises d'une unité à une autre par association d'une première unité Mémorisation Associative en mode lecture transfert à une seconde unité Mémorisation Associative en mode écriture en connectant, avec respect de la distribution des informations, les ports de sorties de la première unité sur les ports entrés de la seconde unité, et en synchronisant le cycle de lecture de la première unité avec le cycle d'écriture de la seconde unité.

Selon l'invention, une unité de mémorisation associative est définie selon la revendication 1. Un dispositif de Mémorisation Associative est composée d'un assemblage de au moins deux sous-unités mémoires similaires à accès par contenu de $2^v$ mots de w bits pour la première, avec v compris entre 1 et w et, de $2^v$ mots de v bits pour la seconde.

La sous-unité Mémoire Associative est programmée en mode écriture par,

- un port d'adresses en mode entrée de v bits,
- un port de données en mode entrée de v ou w bits et
- un port de commande comportant, une horloge entrée binaire de séquencement et deux signaux entrées binaires, l'un de sélection de la mémoire et l'autre d'écriture, ces deux signaux étant validés dans cette séquence d'écriture, permettant, pendant ce cycle, l'enregistrement du mot de v ou w bits présent sur le port de données à la position mémoire adressée par le mot de de v bits sur le port d'adresses,

et cette même sous-unité Mémoire Associative est programmée en mode lecture par, un port de commande comportant, une horloge entrée binaire de séquencement, deux signaux entrées binaires, l'un de sélection de la mémoire valide, et l'autre d'écriture non valide dans cette séquence de lecture et un signal de sortie binaire de validation du contenu présent selon l'invention dans ce mode lecture :

- soit présent un port de sortie des données délivrant une donnée de v ou w bits, précédemment enregistrées en mode écriture, sélectionnée par un mot de v bits présenté sur le port d'adresses entrée et indépendamment,
- soit présent un port de sortie d'adresses de contenu mémoire délivrant une donnée de v bits, correspondant à l'adresse de la donnée de v ou w bits présentée sur le port de données entrée, si précédemment cette donnée de v ou w bits a été enregistrée en mode écriture à au moins une position mémoire, en validant le signal binaire de sortie de validation du contenu présent. Dans le cas contraire où aucune des $2^v$ positions mémoires contiennent la donnée de v ou w bits présentée sur le port de données entrée, la sortie non valide du port de sortie d'adresses de contenu mémoire est signalée par la non validation du signal binaire de sortie de validation du contenu présent.

Dans divers modes de mise en oeuvre de l'invention, les moyens suivants sont employés :

- la mémoire associative soit de technologie non volatile.
- sélectionnée en mode lecture, l'unité Mémorisation Associative soit constituée d'au moins deux sous-unités mémoires similaires associés par deux bus indépendant de v bits :

  - le premier bus, connecté entre le port de sortie d'adresses de contenu mémoire de v bits de la première mémoire associative et le port d'adresses en mode entrée de v bits de la seconde mémoire associative et,
  - le second bus, connecté entre le port de sortie d'adresses de contenu mémoire de v bits de la seconde mémoire associative et le port d'adresses en mode entrée de v bits de la première mémoire associative.

- sélectionnée en mode écriture, l'unité Mémorisation Associative soit constituée d'au moins deux sous-unités mémoires similaires associés par un bus commun de v bits, issu de la sortie d'un compteur binaire de v bits, et connecté au port d'adresses en mode entrée de v bits de chaque mémoire associative.
- l'unité de comptage de $2^v$ valeurs soit à mémorisation non volatile.
- l'unité Mémorisation Associative possède une phase d'initialisation, impliquant l'ensemble des sous-unités mémoires présentes, commandée par une unité d'initialisation des sous-unités mémoires qui est déclenché par la validation des signaux binaires entrées d'initialisation et de sélection de l'ensemble des mémoires issu du port de commande. Cet unité d'initialisation initialise à zéro le compteur binaire de v bits, puis l'incrémente d'une unité à chaque cycle d'horloge entrée binaire de séquencement pendant $2^v$ +1 cycles. Durant ce laps de temps l'unité d'initialisation valide le mode écriture, (signal entrée binaire d'écriture validé), et le forçage à zéro du port entrée des données de chacune des sous unités mémoires. En fin de séquence, toutes les positions mémoires de chacune des sous-unités mémoires sont initialisées à zéro ainsi que le compteur binaire de v bits.
- en dehors de la séquence d'initialisation, le signal entrée binaire de sélection de la mémoire étant validé, le compteur binaire de v bits soit incrémenté d'une valeur unitaire en début de chaque validation du signal d'écriture mémoire,
- le compteur binaire de v bits comporte un signal de limite de comptage en sortie qui devient valide lorsque la valeur binaire du compteur est égale à $2^v$ -1.
- programmée en mode lecture, les sous-unités mémoires soient regroupées en deux ensembles, le premier intégrant n sous-unités mémoires comprenant chacune $2^v$ mots de w bits, le second représenté par une sous-unité Mémoire Associative comprenant $2^v$ mots de v bits, ces deux ensembles étant liés par deux bus antagonistes :

  - le premier bus, issu du port de sortie d'adresses de contenu mémoire de v bits de la sous-unité Mémoire Associative comprenant $2^v$ mots de v bits, est connecté sur le port d'adresses en mode entrée de v bits de chacune des n sous-unités mémoires.

- Le second bus, constitué de la sortie de chacun des ports de sorties d'adresses de contenu mémoire de v bits et de leurs signaux de sortie binaire de validation de contenu respectif présent dans l'ensemble des n sous-unités mémoires, est introduit dans une unité de sélection du maximum de vraisemblance des valeurs d'entrées qui fournit en sortie la valeur sélectionnée la plus représentée. Cette valeur du maximum de vraisemblance est introduite dans le port d'adresses en mode entrée) de v bits de la sous-unité Mémoire Associative comprenant $2^v$ mots de v bits.

- par validation d'un signal entrée binaire de correction en mode lecture, les informations transmises dans le premier bus précédemment décrit soient issu de la sortie de l'unité de valeur du maximum de vraisemblance.

- programmée en mode écriture, la valeur du compteur binaire de v bits soit incrémentée d'une unité en début du cycle d'écriture afin de fournir une valeur correspondante à la nouvelle adresse sur un bus relié à tous les ports d'adresses en mode entrée de v bits de chaque sous-unité Mémoire Associative regroupées en deux ensembles, le premier intégrant n mémoires associatives comprenant chacune $2^v$ mots de w bits, le second représenté par une sous-unité Mémoire Associative comprenant $2^v$ mots de v bits.

- le regroupement de ces deux ensembles de sous-unités mémoires incluant le compteur binaire de v bits, l'unité de calcul du maximum de vraisemblance, l'unité d'initialisation, et les divers éléments logiques de contrôle constitue l'unité de base de la Mémorisation Associative.

- en mode lecture, l'unité Mémorisation Associative associe un message (MEin_i) constitué de n sous-messages (RSin_1 à RSin_n) indépendant de w bits en entrée à un label (Lout_j) de v bits en sortie et, vice versa en entrée un label (Lin_i) de v bits associe en sortie un message (MEout_j) constitué de n sous-messages (RSout_1 à RSout_n) indépendant de w bits: la présence d'un message (MEin_i) même partiel présenté à l'unité de base de la mémoire associative (10) fourni en sortie un label (Lout_i), en retour, ce label devient (Lin_i) et, étant connecté en entrée à l'unité Mémorisation Associative (10), délivre le message (MEout_i) complet correspondant précédemment appris.

- chaque sous-messages indépendant entrant (RSin_x) et sortant (RSout_x) de w bits soit structuré chacun en p éléments de w/p bits avec, pour chaque élément, une définition propre à son emplacement.

- chaque élément de w/p bits puisse être mis indépendamment si nécessaire en mode accès par contenu ternaire (TCAM).

- le sous-message (RSout_x) de w bits sortant de l'unité Mémoire Associative soit connecté à l'unité de registres d'entrée d'un attracteur dynamique et que l'unité de registres résultat de ce même attracteur dynamique délivre le sous-message entrant (RSin_x) de w bits de l'unité Mémoire Associative.

- les p éléments de w/p bits du sous-message indépendant entrant (RSin_x) et sortant (RSout_x) de w bits aient, comme définition propre à son emplacement, une représentation sémantique élémentaire de type globale, dynamique ou structurale.

- l'attracteur dynamique extrait, des flots de données séquencés à sous séquences issue d'une unité de conversion d'un flow de données entrant, une représentation sémantique élémentaire de type globale, dynamique, structurale et, référencée en position correspondant à un sous-message.

- par recrutement dynamique des attracteurs dynamiques avec inhibition des antécédents (chainage Cout de l'attracteur dynamique à Cin de l'attracteur dynamique. Chaque attracteur dynamique en fonction définit un sous-message (RSin_x) dont l'ensemble correspond au message (ME_in) transmis

- les unités de bases Mémorisation Associative se connectent en mode pyramidal inverse, un premier niveau de p unités de base de Mémoire Associative reçoit p messages et génère p labels qui se connectent chacun en tant que sous-message d'une unités de base de Mémoire Associative en second niveau en générant un label récapitulatif des sous-messages entrant, et en inverse un second label récapitulatif entrant dans cette unité de base de mémoire associative génère un ensemble de sous-messages qui se connectent en tant que label associé à un sous-message à l'ensemble des p unités de base de mémoire associative du premier niveau et délivre un ensemble de p messages.

- l'on associe les sous-unités mémoires représentant l'unité de base Mémoire Associative en mode lecture par un bus commun de v bits, issu de la sortie d'un compteur binaire de v bits, et connecté au port d'adresses en mode entrée de v bits de chaque sous-unité Mémoire Associative, ce compteur binaire de v bits étant initialisé à zéro puis incrémenté d'une unité par la commande d'un signal binaire T de transfert. A chaque séquence de transfert, la valeur du message et de son label associé sont accessibles.

- le transfert de connaissance des Mémorisations Associatives acquises d'une unité à une autre est fait par association d'une première unité Mémorisation Associative en mode lecture transfert à une seconde unité Mémorisation Associative en mode écriture en connectant, avec respect de la distribution des informations, les ports de sorties de la première unité sur les ports entrés de la seconde unité, et en synchronisant le cycle de lecture de la première unité avec le cycle d'écriture de la seconde unité.

L'invention concerne également les applications suivantes du procédé et du dispositif définis selon les revendications :

- l'unité de base de la mémoire associative soit intégré en un composant électronique.
- l'unité de base de la mémoire associative soit empilée sur une puce électronique.

**Description de l'invention**

La présente invention va maintenant être exemplifiée dans la description qui suit, sans pour autant en être limitée, et en relation avec les figures suivantes :

la **figure 1** représente, dans sa généralité, un dispositif décrivant la sous-unité Mémoire Associative (1_1),
la **figure 2** une illustration du mode écriture de l'unité Mémoire Associative (10) intégrant plusieurs sous-unités Mémoire Associative (1_i) de la **figure 1,**
la **figure 3,** un exemple de groupement de deux sous-unités Mémoire Associative en mode lecture,
la **figure 4,** une illustration du mode de fonctionnement de la **figure 3** étendu à plus de deux sous-unités et intégrant une unité de calcul de maximum de vraisemblance et un mode de fonctionnement bouclé, (Cor)=1,
la **figure 5,** un exemple de l'unité de Mémoire Associative en mode initialisation,
la **figure 6,** une illustration du mode de fonctionnement de l'unité de Mémoire Associative (10) en mode transfert de connaissance,
la **figure 7,** un exemple de transfert de connaissance entre deux unités de Mémoire Associative (10_1) et (10_2),
la **figure 8,** une illustration du mode de correction du message d'entrée par maximum de vraisemblance,
la **figure 9,** une illustration de l'unité de Mémoire Associative (10) dans son ensemble,
la **figure 10,** un exemple d'utilisation de la Mémoire Associative (10) en combinaison d'unités attracteurs dynamiques (80_i),
la **figure 11,** une illustration de la fonction de transfert de l'unité de traduction (70),
la **figure 12,** une illustration de l'organisation des calculs d'histogrammes bilinéaires de l'unité attracteur dynamique (80_i),
la **figure 13,** un exemple d'assemblage en mode pyramidal de trois unités Mémoire Associative (10_1) à (10_3) créant l'unité de base générateur universel de graphe hiérarchique (60),
la **figure 14,** une illustration du mode de composition d'un graphe générant un label à partir des traitements des messages mémorisés,
La **figure 15,** un exemple d'utilisation d'une unité de Mémoire Associative (10) commandant la réponse à un stimulus,
la **figure 16,** un mode d'intégration de l'unité de Mémoire Associative (10) en un composant électronique générique,
la **figure 17,** un mode d'intégration de l'unité de Mémoire Associative (10) sur un wafer.

**Description détaillée de l'invention**

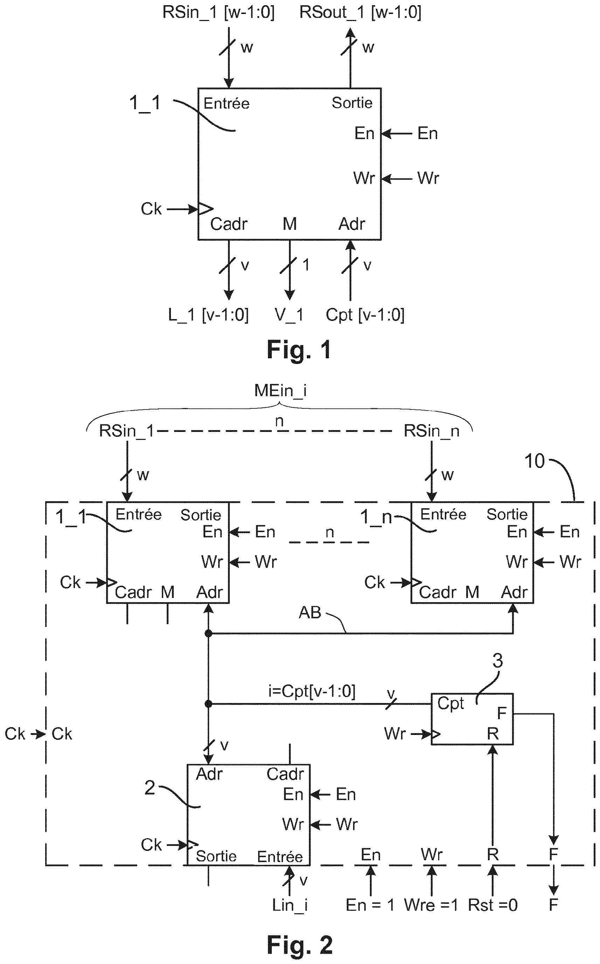

La **figure 1** représente l'élément de base de l'unité Mémorisation Associative (10) : la sous-unité mémoire (1_1) d'un ensemble de n sous-unités mémoires TCAM ou CAM indépendantes notée de (1_1) à (1_n), i étant le numéro de l'unité (1_i). Ces sous-unités mémoire peuvent fonctionner en mode RAM ou CAM, et sont non volatile. Selon différents modes de réalisation de l'invention, ces sous-unités mémoires peuvent être de différents types, par exemple du type STT-MRAM *(spin transfert torque magnetic random access memory),* ferroRAM ou NRAM, ou de tout autre type permettant à la mémoire de fonctionner en mode RAM ou CAM. Le comportement est celui d'une mémoire RAM et CAM par l'intégration de la fonction de comparaison logique au sein de chaque cellule mémoire élémentaire, le doublement de la jonction spintronique permet un troisième état de correspondance appelé "X", pour former une mémoire TCAM. Chaque sous-unité mémoire (1_i) de $2^v$ mots de w bits se compose :

- d'un port d'entrée (in) de w bits,
- d'un port de sortie (out) de w bits,
- d'un port d'entrée d'adresses mémoire (Adr) de v bits,
- d'un port de sortie (Cadr) de v bits associé à un signal de sortie binaire de validation de comparaison (M),
- d'un port de commande composé des signaux entrés binaires de commandes (En) et (Wr) et d'un signal d'entrée binaire horloge (Ck) de séquencement.

Pour chacune des sous-unités mémoire (1_i), existe trois états possibles suivant le niveau des signaux, issu du bus de commande, (En) et (Wr), séquencés par un signal d'horloge (Ck) présent respectivement sur le port de commande en position (En), (Wr), et (Ck) :

i) Les signaux (En) et (Wr) sont inactifs. La sous-unité mémoire (1_i) est figée, sa consommation est quasi nulle.
ii) Le signal (En) actif et le signal (Wr) inactif déclenchent le mode lecture CAM pour le message (RSin_i) de w bits présent sur son entrée (in) qui est comparé au contenu de toutes les adresses mémoires de la sous-unité mémoire (1_i) afin de sortir l'adresse (L_i) de v bits contenant le message (RSin_i), dans la sous-unité mémoire (1_i) sur le port (Cadr) si présent en validant un signal (M), et en invalidant ce signal (M) dans le cas contraire. De même, le signal (En) actif et le signal (Wr) inactif déclenche le mode lecture RAM pour une donnée (Cpt) de v bits positionnée en entrée sur le port d'adresse (Adr) qui valide une position mémoire dont son contenu (RSout_i) de w bits est transmis sur le port de sortie (out).

iii) Les signaux (En) et (Wr) actifs déclenchent le mode écriture RAM pour le sous-message (RSin_i) présent sur le port entré (In) qui est mémorisé à l'adresse mémoire (Cpt) présente sur le port d'entré (Adr).

La **figure 2** détaille le mode écriture de l'unité Mémoire Associative (10) consistant à mémoriser un message (MEin_i), composé de n sous-messages (RSin_1) à (RSin_n), et un label (Lin_i) à une adresse mémoire commune ayant la valeur i égale à (Cpt[v-1 :0]) délivrée par l'unité de comptage de $2^v$ valeurs (3) à mémorisation non volatile, incrémenté d'une valeur unitaire à chaque action de mémorisation.

Cette unité Mémoire Associative (10) comporte, une unité de comptage de $2^v$ valeurs (3) délivrant la valeur i, et deux ensembles de sous-unités mémoire similaires dont une sous-unité mémoire (1_1) est décrite en figure 1. Le premier ensemble se compose de n sous-unités mémoire, composée chacune de $2^w$ mots de w bits, notées de (1_1) à (1_n), et recevant chacune sur leur port d'entré (In) respectivement le sous-message (RSin_1) pour la sous-unité mémoire (1_1) jusqu'au sous-message (RSin_n) pour la sous-unité mémoire (1_n). Le second ensemble se compose d'une sous-unité mémoire de $2^v$ mots de v bits (2) recevant sur le port d'entré (In) le label (Lin_i).

Le mode écriture de l'unité Mémoire Associative (10) est activé par la validation des signaux binaire (En) et (Wr) positionnés sur le port de commande de chacune des sous-unités mémoires (1_1) à (1_n) et (2). La validation du signal binaire (Wr) incrémente d'une unité l'unité de comptage de $2^v$ valeurs (3), la commande d'initialisation (R) de cette unité de comptage (3) est maintenue à zéro durant tout le processus du mode écriture de l'unité Mémoire Associative (10) par l'entrée binaire externe (Rst)=0. Cette nouvelle valeur i de compteur (3) égale à (Cpt[v-1 :0]) est présenté au port entré adresse (In) de chaque sous-unité mémoire sans exception. Le signal d'horloge (Ck) de séquencement, présenté sur chaque sous-unité mémoire, valide la mémorisation générale de toutes les sous-unités mémoire présente dans cette unité Mémoire Associative (10). Le nombre d'opérations de mémorisation de cette unité Mémoire Associative (10) est limité par la valeur maximale $2^v$ -1 de l'unité de comptage (3) qui délivre pour cette valeur un signal binaire de limite (F).

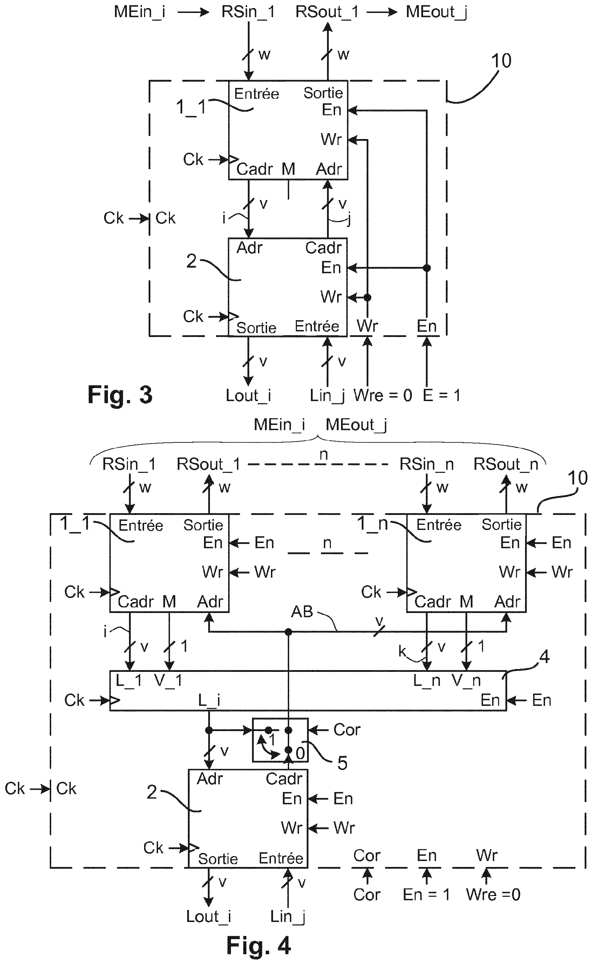

La **figure 3** détaille le mode lecture de l'unité Mémoire Associative (10) dans sa mise en oeuvre la plus simple où chaque ensemble n'est constitué que d'une sous-unité mémoire.

Le mode lecture de l'unité Mémoire Associative (10) est activé par la validation du signal binaire (En) et l'annulation du signal (Wr), tous deux positionnés sur le port de commande de chacune des sous-unités mémoires (1_1) et (2)

Le message (MEin_i) correspond au sous-message (RSin_1) présenté sur le port entré (In) de la sous-unité mémoire (1_1). La position i de la sous-unité mémoire (1_1) contenant la valeur (RSin_1) est délivrée sur son port de sortie (Cadr) de v bits et présenté sur le port entrée (Adr) de la sous-unité mémoire (2). Le contenu (Lout_i) de la sous-unité mémoire (2) en position i est délivré sur son port de sortie (Out).

Le label (Lin_j) présenté sur le port entrée (In) de la sous-unité mémoire (2) délivre la valeur j de la position contenant la valeur (Lin_j) sur son port de sortie (Cadr) de v bits qui est présenté sur le port entrée (Adr) de la sous-unité mémoire (1_1). Le contenu (RSout_j) de la sous-unité mémoire (1_1) en position j est délivré sur son port de sortie (Out). Ce sous-message (RSout_j) correspond au message MEout_j.

Ce mode lecture de l'unité Mémoire Associative (10) montre l'association du message (MEin_i) au label (Lout_i) et inversement du label (Lin_j) au message (MEout_j).

La **figure 4** est une extension du mode lecture de l'unité Mémoire Associative (10), décrit dans la **figure 3,** dans sa mise en oeuvre générique où le message (MEin_i) est constitué de n sous-messages, (RSin_1) à (RSin_n). Le premier ensemble se compose de n sous-unités mémoires, composée chacune de $2^w$ mots de w bits, notées de (1_1) à (1_n), et recevant chacune sur leur port d'entrée (In) respectivement le sous-message (RSin_1) pour la sous-unité mémoire (1_1) jusqu'au sous-message (RSin_n) pour la sous-unité mémoire (1_n). Le second ensemble se compose d'une sous-unité mémoire de $2^v$ mots de v bits (2) recevant sur le port d'entrée (In) le label (Lin_j).

Dans le sens label vers message, le procédé est identique à celui décrit à la **figure 3.** La présentation de (Lin_j) sur le port entrée (In) de la sous-unité mémoire (2) entraine la délivrance de la valeur j sur son port de sortie (Cadr), cette valeur j est transmise au bus AB au travers d'une unité de choix de valeur de lien (5) et est présentée à toutes les sous-unités mémoire (1_1) à (1_n) qui délivre chacune sur son port de sortie (Out) le sous-message respectivement (RSout_1) à (RSout_n) qui, ensemble, forme le message (MEout_j).

Dans le sens inverse, message vers label, les sous-messages (RSin_1) à (RSin_n), correspondant au message (MEin_i), sont présentés respectivement sur le port entrée (In) de chaque sous-unité mémoire (1_1) à (1_n) qui délivrent chacune une valeur i, ou autre k sur leur port de sortie (Cadr) respectif en association à un signal binaire de validation débité par la sortie (M) de la même sous-unité mémoire. Dans le cas où le sous-message présenté est absent de la sous-unité mémoire, celle-ci délivre sur sa sortie (M) un signal binaire de non validation, la valeur présente sur son port de sortie (Cadr) est alors ignorée.

Une unité de calcul de maximum de vraisemblance (4) est introduite dans l'unité Mémorisation Associative (10) afin de sélectionner la valeur i, k ou autre la plus représentée. Cette unité (4) reçoit du port de sortie (Cadr) de chaque sous-unité mémoire (1_1) à (1_n) une valeur i, ou autre k respectivement sur un port entré (L_i) à (L_n) avec leur signal binaire respectif de validation sur l'entré respectivement (V_1) à (V_n). Le séquencement interne est assuré par un signal horloge (CK) introduit dans l'unité (4). Le choix du maximum de vraisemblance est positionné sur le port de sortie (L_i), un bus de v bits transmet cette valeur au port entrée (Adr) de la sous-unité mémoire (2) qui délivre sur son port de sortie (Out) la valeur du label (Lout_i).

Une unité de choix de valeur de lien (5) de v bits commandé par un signal binaire (Cor) permet d'avoir deux modes de fonctionnement. La valeur binaire (Cor) est invalide, la description de fonctionnement correspond à ce qui vient d'être décrit. La validation du signal binaire (Cor) commute le bus (AB) du port de sortie (Cadr) de la sous-unité mémoire (2) vers le port de sortie (L_i) de l'unité (4), ce qui permet la sortie d'un message (MEout_i) corrigé du message entrant (MEin_i) déformé ou partiel. Ce mode de réalisation offre un pouvoir de remémoration élevé, notamment en présence d'effacement ou de messages partiels.

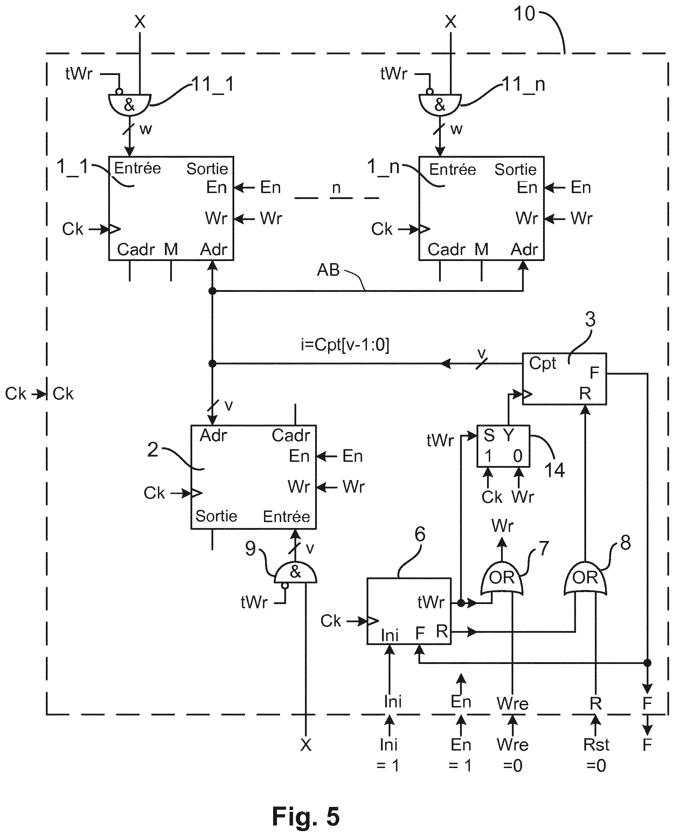

La **figure 5** détaille la séquence d'initialisation de l'unité Mémoire Associative (10), indispensable à son bon fonctionnement. Le but étant d'écrire la valeur zéro dans toutes les cellules mémoires des sous-unités mémoire présentes dans l'unité Mémoire Associative (10) et d'initialiser le compteur (4) à zéro, afin de pouvoir ensuite, en mode lecture, mémoriser $2^v$ -2 valeurs des messages excepté zéro.

A la description précédente de l'unité Mémoire Associative (10), sont ajoutés, une unité de séquencement de l'initialisation (6) commandée extérieurement par un signal binaire (Ini), des sous-unités mémoires ainsi que des éléments logiques (7), (8), (9), (11_1) à (11_n) et (14) permettant le fonctionnement d'initialisation.

Pendant tout le cycle d'initialisation, le signal binaire (tWr) délivré par l'unité de séquencement de l'initialisation (6) est maintenu valide. Le port entrée (In) de chacune des sous-unités mémoires (1_1) à (1_n) et (2) présentes dans l'unité Mémoire Associative (10) reçoit, respectivement, une donnée égale à zéro délivrée par une unité logique à w portes (11_1) à (11_n) contrôlant, respectivement chacune, les sous-messages (RSin_1) à (RSin_n) et, une unité logique à v portes (9) contrôlant le label (Lin_i). Chaque porte logique est une fonction booléenne « ET » à deux entrées dont une est inversée et reçoit le signal binaire (tWr) et la seconde reçoit un des bits des sous-messages ou label. Chaque bit des sous-messages ou label est, transmis lorsque le signal binaire (tWr) est non valide ou, forcé à zéro lorsque le signal binaire (tWr) est valide.

L'unité de séquencement de l'initialisation (6) est séquencée par le signal horloge (CK), cette unité (6) reçoit le signal binaire de commande (Ini) ainsi qu'un signal binaire (F) signalant la limite de comptage du compteur (3) et sort un signal binaire (R) de commande de mise à zéro du compteur (3) et un signal binaire d'initialisation (tWr), valide pendant toute la durée de l'initialisation.

La validation du signal d'initialisation (Ini) pendant au moins le temps d'un cycle d'horloge (Ck) valide la fonction d'initialisation de l'unité Mémoire Associative (10). Cette initialisation débute par la validation pendant un premier cycle d'horloge (Ck) du signal binaire (R) de commande de mise à zéro du compteur (3). Cette sortie (R) est connectée à l'entrée (R) de ce compteur (3) au travers d'une porte logique « OU » (8) à deux entrées, la seconde entrée recevant le signal binaire externe (Rst) de remise à zéro de ce compteur (3) dont sa valeur est maintenue à zéro durant le temps de cette initialisation. Ce compteur (3) initialise la valeur de sortie (Cpt) égale à zéro dès le début du cycle d'initialisation. Le second cycle d'horloge (Ck) valide en sortie le signal binaire d'initialisation (tWr). Ce signal binaire d'initialisation (tWr) est connecté aux unités logiques (7), (14), (11_1) à (11_n) et (9). L'unité logique (7) est une porte logique « OU » à deux entrées validant le signal binaire (Wr) interne au circuit issu soit de la sortie (tWr) de l'unité (6) soit de l'entrée externe (Wr) dont sa valeur est maintenue à zéro durant le temps de cette initialisation. L'unité logique (14) est un multiplexeur à deux entrées dont la sortie, connectée à l'entrée de l'unité de comptage (3) permet son incrément, correspond au signal binaire d'horloge (Ck) lorsque l'entrée de sélection (S) de cette même unité (14) reçoit le signal (tWr) valide et au signal binaire interne (Wr), issu de l'unité (7), lorsque l'entrée de sélection (S) de cette même unité (14) reçoit le signal (tWr) invalide. Chaque cycle d'horloge (Ck) incrémente d'une unité chaque adresse mémoire en écrivant la valeur zéro en mémoire jusqu'à la valeur finale, égale à $2^v$ -1, de l'unité de comptage (3) qui délivre à ce moment un signal de sortie (F) connecté à l'unité d'initialisation (6) qui au cycle suivant incrémente une dernière fois l'unité de comptage (3) qui repasse à zéro et dé-valide son signal de sortie (tWr), ce qui finalise le cycle d'initialisation.

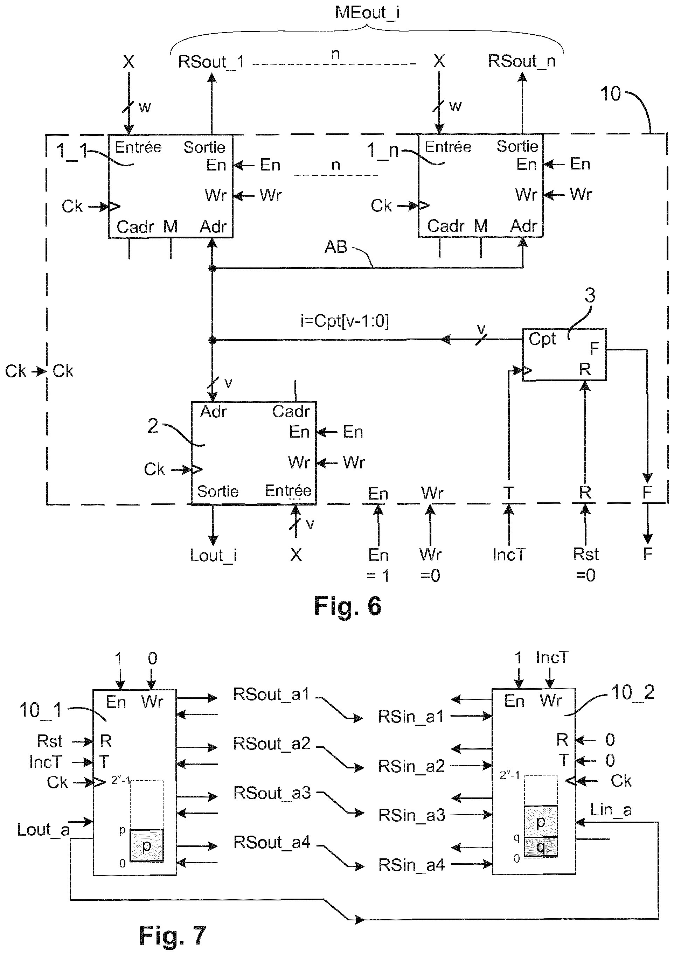

La **figure** 6 détaille le mode transfert de connaissance d'une unité Mémoire Associative (10) vers une unité externe. L'organisation interne de cette unité (10) correspond à la description faite de la figure 2 à l'exception du signal binaire (Wr) qui est non valide et d'un signal binaire de transfert externe (IncT) qui est connecté sur l'entrée d'incrément de l'unité de comptage (3). Toutes les sous-unités mémoires (1_1) à (1_n) et (2) sont en mode lecture et valide respectivement sur leurs port de sortie (Out) les sous-messages (RSout_1) à (RSout_n) correspondant au message (MEout_i) et (Lout_i) accessible à l'extérieur de l'unité Mémoire Associative (10). Le mode transfert débute par une initialisation à zéro de l'unité de comptage (3) en validant le signal binaire externe (Rst) pendant un court instant, puis le signal externe de transfert (IncT) est activé et désactivé par cycle de lecture. A chaque cycle de lecture, un couple de message (MEout_i) et label (Lout_i) est lu, un couple valant zéro indique la fin du transfert.

La **figure 7** représente un transfert de connaissance de p informations d'une unité Mémoire Associative (10_1) dans une unité Mémoire Associative (10_2) possédant une connaissance de q informations. Les sorties sous-messages (RSout_a1) à (RSout_a4) et label (Lout_a) de la première unité Mémoire Associative (10_1) sont connectées respectivement sur les entrées sous-messages (RSin_a1) à (RSin_a4) et label (Lin_a) de la seconde unité Mémoire Associative (10_2). Le signal (En) valide (=1) connecté sur les deux unités (10_1) et (10_2) valide ces unités. Une courte validation de signal binaire (Rst) sur l'unité (10_1) initialise à zéro le compteur (3) interne. Le signal de transfert (IncT) est connecté sur l'entrée (T) de la première unité (10_1) et sur l'entrée (Wr) de la seconde unité (10_2). Les entrées (Wr) de la première unité (10_1) et (R), (T) de la seconde unité (10_2) sont mises à zéro (non valide). L'horloge de séquencement (Ck) est connectée sur les deux unités (10_1) et (10_2). Puis le signal externe de transfert (IncT) est activé et désactivé par cycle de lecture. A chaque cycle de lecture, un couple de message (MEout_i) et label (Lout_i) est transféré de l'unité (10_1) à (10_2), un couple valant zéro indique la fin du transfert. En fin de transfert, l'unité Mémoire Associative (10_2) contient p+q couples message-label. Chaque unité (10_1) et (10_2) redevient libre de mémoriser un nouveau couple, le premier après les p enregistrés, le second après les p+q enregistrés.

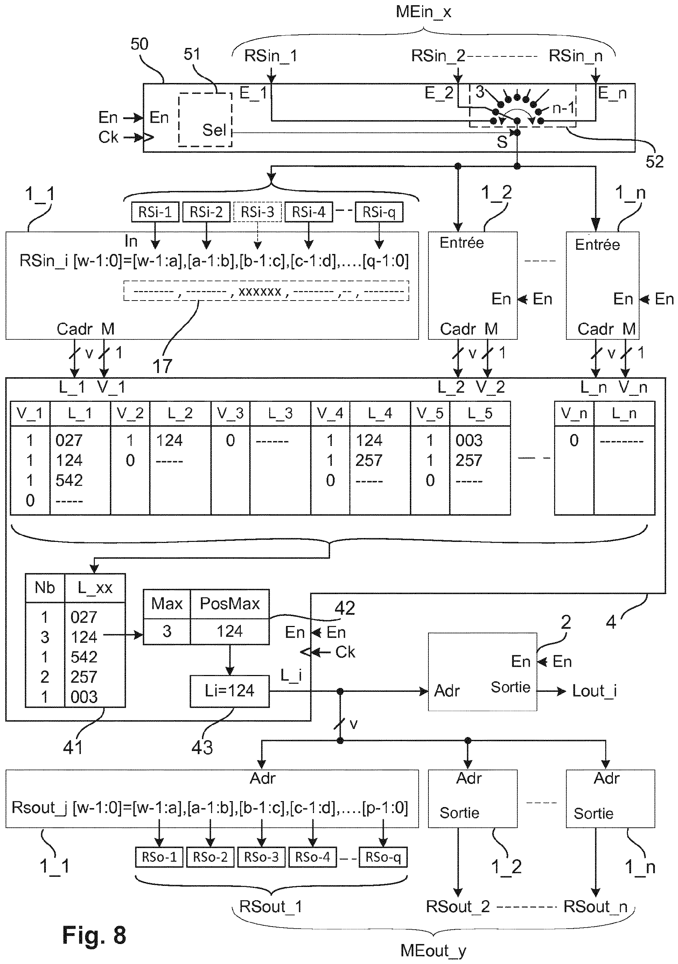

La **figure 8** détaille l'organisation du message présenté, son calcul du maximum de vraisemblance et le choix du label associé en sortie Pour plus de clarté, le signal binaire de validation (En), valide, et son horloge de séquencement (Ck) de l'unité Mémoire Associative (10) sont non représentés.

Un message entrant (MEin_x) se compose de un à plusieurs (n) sous-messages chacun de dimension (w) bits dénommés pour ce message entrant (RSin_1) à (RSin_n). Ces sous-messages n'étant pas forcément ordonnés, par exemple le sous-message (RSin_1) peut être mis placé en une autre position lors de son apprentissage, une unité de choix de position (50) va placer en sortie séquentiellement chacun des sous-messages de 1 à n. Lorsque le signal de commande (En) est validé, l'horloge de séquencement pilote une unité séquenceur (51) qui commande une unité de multiplexeur à n entrées de w bits (52) connectées chacune à un sous-message entrant (RSin_1) à (RSin_n) et sa sortie connectée à toutes les entrées (In) des sous-unités mémoire (1_1) à (1_n).

Tous les sous-messages ont une organisation en mot de w bits segmenté en q éléments de w/q bits (division entière) dénommé (RSi-1) à (RSi-q) correspondant à la position des bits [w-1 :a] pour (RSi-1), [a-1 :b] pour (RSi-2) jusqu'à [q-1 :0]. Chaque élément de w/q bits correspond à une entité référencée. Dans le cas où cet élément est mal référencé ou absent, par exemple le sous-message (RSi-3) en position [b-1 :c], le mode TCAM (17) permet de positionner cette partie en xxxx, elle sera toujours validé.

Chaque sous-unité mémoire (1_1) à (1_n) vérifie ainsi la présence ou non des sous-messages (RSin_1) à (RSin_n). En cas de présence, la sous-unité mémoire positionne sur son port de sortie (Cadr) l'adresse du contenu mémoire et valide son signal binaire (M). L'unité de calcul de vraisemblance (4) reçoit sur ses entrées, (L_1) le contenu du port de sortie (Cadr) de la sous-unité mémoire (1_1) et, (V_1) la sortie binaire (M) de validation de cette même sous-unité mémoire. Il en va de même pour les connexions des autres sous-unités mémoire (1_2) à (1_n). (Même indice sur les sorties et entrées précitées). Le processus de choix d du maximum de vraisemblance mis en oeuvre dans l'unité (4) est explicité par cet exemple :

Le message entrée MEin_x est composé des sous-messages (RSin_1) à (RSin_n) qui sont séquencés l'un après l'autre par l'unité (50). En fin des n séquences, l'unité (4) a reçu de chaque sous-unité mémoire (1_1) à (1_n) respectivement les données associées (V_1), (L_1) à (V_n), (L_n), présentées dans le tableau ci-dessous :

| V_1 | L_1 | V_2 | L_2 | V_3 | L_3 | V_4 | L_4 | V_5 | L_5 | ------- | V_n | L_n |
|---|---|---|---|---|---|---|---|---|---|---|---|---|
| 1 | 027 | 1 | 124 | 0 | ----- | 1 | 124 | 1 | 003 | | 0 | ---- |
| 1 | 124 | 0 | ----- | | | 1 | 257 | 1 | 257 | ---- | | |
| 1 | 542 | | | | | 0 | ----- | 0 | ----- | | | |
| 0 | ----- | | | | | | | | | | | |

Durant cette séquence de défilement des n sous-messages, la sous-unité mémoire (1_1) a trouvé trois contenus mémoire présent dont leurs adresses 027, 124, et 542 ont été présentées sur l'entrée (L_1) et validé par (V_1) de l'unité (4). La non validation de (V_1) indique la non prise en compte de la donnée présentée sur l'entrée (L_1). De la même façon, la sous unité mémoire (1_2) a trouvé un contenu mémoire présent dont son adresse 124 a été présentée sur l'entrée (L_2) et validé par (V_2) de l'unité (4). Respectivement, la sous unité mémoire (1_3) n'a rien délivré, la sous unité mémoire (1_4) a délivré deux données 124 et 257, la sous unité mémoire (1_5) a délivré deux données 003 et 257, et les sous unités mémoire suivantes jusqu'à (1_n) n'ont rien délivré. Une sous-unité (41) de l'unité (4) comptabilise le nombre de fois que la donnée entrée a été présente, soit dans cet exemple, la donnée 127 a été présente une fois, la donnée 124 trois fois, 542 une fois, 257 deux fois et 003 une fois. La sous-unité (42) sélectionne la donnée la plus représentée, soit dans cet exemple la donnée 124 avec un maximum de 3 fois, et la transmet au registre (43) représentant la donnée positionnée en port de sortie (Li) de l'unité (4) en communication avec un bus de v bits, lui-même connecté aux ports d'entrée (Adr) de toutes les sous-unités mémoires (1_1) à (1_n) et (2). Les sous-unités mémoires (1_1) à (1_n) délivrent sur leur port de sortie respectif (out) les sous-messages (RSout_1) à (RSout_n) représentant le message de sortie (MEout_y) dont tous les éléments des sous-messages sont corrigés (correspondant au paterne appris précédemment).

Dans le cas où la sous-unité (41) de l'unité (4) trouve deux données distinctes en quantité équivalente, arbitrairement, c'est la donnée la plus faible qui est choisi. C'est par exemple la perception visuelle d'une figure indécidable comme le blivet de Norman Mingo.

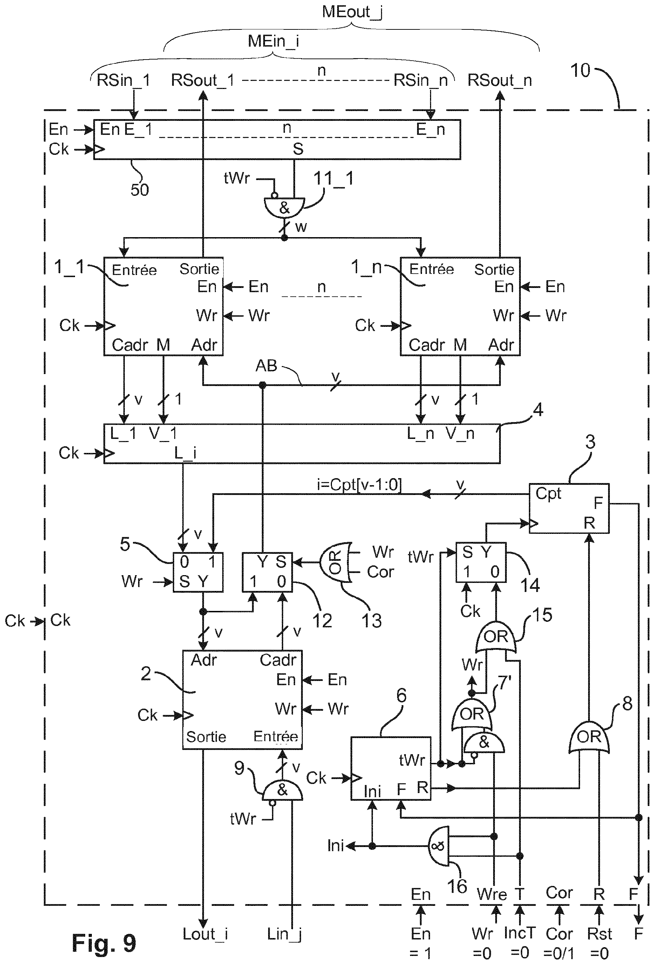

La **figure 9** détaille le fonctionnement du dispositif unité Mémoire Associative (10) intégrant les différents modes décrit précédemment à savoir un mode, passif (arrêt des diverses fonctions), lecture en relation avec la figure 4, transfert en relation avec la figure 6, écriture en relation avec la figure 2, et initialisation en relation avec la figure 5. Le tableau ci-dessous donne la correspondance entre la valeur des signaux (En), (Wr) et (T) du bus de commande et le mode fonctionnel sélectionné :

| Mode\Bus commande | En | Wre | T |
|---|---|---|---|
| Arrêt | 0 | X | X |
| Lecture | 1 | 0 | 0 |
| Transfert | 1 | 0 | 1 |
| Ecriture | 1 | 1 | 0 |
| Initialisation | 1 | 1 | 1 |

Le regroupement des différents modes fonctionnels implique certains aménagements de l'unité Mémoire Associative (10) précédemment décrite par les figures 1 à 6.

Le bus Cpt[v-1 ;0] délivré par l'unité de comptage (3) est introduit dans une des deux entrées de l'unité multiplexeur (5), la seconde entrée étant délivrée par la sortie (L_i) de v bits de l'unité de calcul du maximum de vraisemblance (4). La sélection (S) de l'unité (5) est pilotée par le signal binaire (Wr), la sortie (Y) de cette unité (5) correspond à la valeur de (Cpt) pour le signal binaire (Wr) valide et à la valeur de (L_i) dans le cas contraire. La sortie (Y) de cette unité (5) est connectée au port entrée (In) de la sous-unité mémoire (2) et à une des deux entrées d'un second multiplexeur (12), la seconde entrée de ce multiplexeur (12) étant relié au port de sortie (Cadr) de la sous-unité mémoire (2). La sélection (S) de l'unité (12) est pilotée par la sortie d'une unité logique « OU » (13) à deux entrées recevant les signaux binaire (Wr) et (Cor) respectivement sur chacune de ses entrées. La sortie (Y) du multiplexeur (12) est connectée au port entrée (Adr) de chaque sous-unité mémoire (1_1) à (1_n).

L'unité logique « OU » (7), assurant la fonction booléenne Wr=tWr+Wre, est remplacée par l'unité logique « OU-ET » (7') assurant la fonction booléenne Wr=tWr+Wre.t$\overline{W}$r avec les mêmes connexions que pour l'unité (7).

Le signal entrée (Wr) du multiplexeur (14) est remplacé par la connexion de la sortie de l'unité logique « OU » (15) à deux entrées recevant les signaux binaire (Wr) et (T) respectivement sur chacune de ses entrées.

Le signal binaire de commande du mode initialisation (Ini) est généré par une unité logique « ET » (16) à deux entrées recevant les signaux binaires (Wre) et (T) respectivement sur chacune de ses entrées.

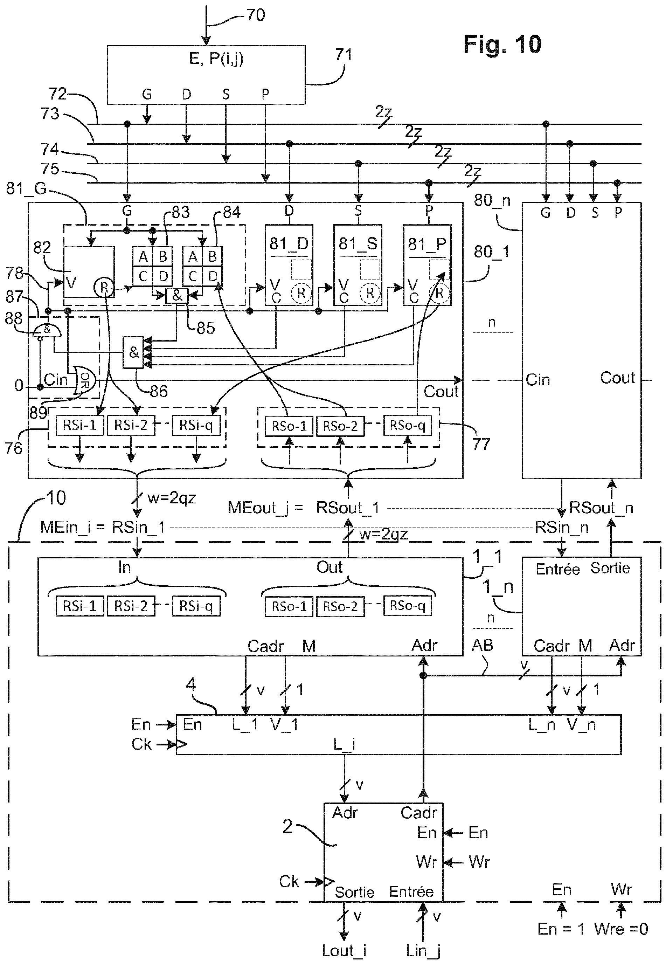

La **figure 10** illustre un exemple d'utilisation de la Mémoire Associative (10) en combinaison d'unités attracteurs dynamiques (80_i) et d'une unité de transfert de traduction (71). Pour plus de clarté, les signaux de séquencement ont été omis.

**L'unité de transfert de traduction (71).**

Des données spatio-temporelles (70) issues d'un élément amont, ici non représenté, sont délivrées sur le port entrée (E, P(i,j)) d'une unité de transfert de traduction (71) qui débite à son tour d'une manière synchrone, cadencé par un signal d'horloge (Ck), des représentations sémantiques élémentaires référencées en position sur ses ports de sorties G, D, S, et P. Chaque port de sortie G, D, S, et P est connecté indépendamment et respectivement, sur le bus G (72), le bus D (73), le bus S (74) et le bus P (75) de taille identique de 2z bits. Les n unités attracteur dynamique (80_1) à (80_n) se connectent à ces quatre bus, respectivement sur leur port d'entrée G, D, S, et P.

**L'unité attracteur dynamique (80_1)**

L'unité attracteur dynamique (80_1) est représentée plus en détail afin d'en expliciter le fonctionnement, sachant que toutes les unités attracteurs dynamiques (80_1) à (80_n) sont identiques. Cette unité attracteur dynamique (80_1) inclut :

- quatre unités traitement statistique (81_G), (81_D), (81_S), et (81_P) identiques. Chaque unité traitement statistique (81_x) comporte :

    ○ une unité de calcul histogramme bilinéaire (82), comportant

        ▪ Une entrée données (x) correspondant à G ou D ou S ou P suivant l'unité traitement statistique (81_x).
        ▪ Une unité de registres résultats (R).
        ▪ Une entrée de validation du calcul d'histogramme bilinéaire (V)
        ▪ une unité de séquencement, ici non représentée, dépendant du mode de fonctionnement, soit par séquence soit par nombre d'évènements, qui assure, cycliquement en séquence, la phase d'initialisation, la phase calcul histogramme, la phase mise à jour registres (R) et la phase classification automatique.

    La phase d'initialisation consiste à mettre à zéro la mémoire de stockage des calculs d'histogramme et à initialiser les divers registres de calcul. Durant la phase calcul histogramme, à chaque donnée (x) présentée correspond un signal d'entrée (V) qui valide ou non le calcul.
    En fin de séquence ou dès que la valeur maximale de l'histogramme dépasse un seuil paramétré extérieurement, suivant le mode utilisé, les registres (R) sont actualisés ainsi que les registres de l'unité de classification automatique (83). Parmi les valeurs calculées, le nombre de calcul NBPTS, la médiane Med, la valeur du maximum RMAX, sa position PosRMX ainsi que les bornes de classification A, B, C, et D.
    ○ deux unités de classification automatique (83) et requête (84) recevant chacun les données 2z bits du port d'entrée (x) et délivrant un signal binaire de classification valide s'il est compris entre ses bornes de classification ; A et B pour les z bits de poids fort et, C et D pour les z bits de poids faible.
    ○ une unité booléenne de validation de classification (85) reçoit les signaux binaires de classification des deux unités de classification automatique (83) et requête (84). Le ET logique entre ces deux signaux binaires de classification est transmis hors de l'unité traitement statistique (81_x).

- Une unité booléenne de classification spatio-temporelle (86) reçoit les signaux binaires de classification des quatre unités traitement statistique (81_G), (81_D), (81_S), et (81_P) pour en faire un ET logique qui est transmis à l'unité de validation de calcul d'histogramme (87).
- Une unité de validation de calcul d'histogramme (87) comprend une unité logique ET à deux entrées dont une inversés (88) et une unité logique OU à deux entrées (89). L'unité logique ET (88) reçoit en direct le signal binaire issu de l'unité logique ET (86) et en inverse le signal binaire entrée (Cin) de l'unité (80_1) et délivre un signal binaire de validation de calcul d'histogramme sur l'entrée (V) de chaque unité traitement statistique (81_G), (81_D), (81_S), et (81_P). L'unité logique OU (89) reçoit le signal binaire entrée (Cin) de l'unité (80_1) et le signal binaire de validation de calcul d'histogramme de l'unité logique ET (88) et délivre un signal binaire d'inhibition sur le port de sortie (Cout) de l'unité (80_1).
- Une unité de registres de sortie (76) comporte les registres (RSi-1) à (RSi-q) mis à jour à chaque dépassement de la valeur NBPTS par rapport à un seuil paramétré extérieurement. L'ordre des registres (RSi-1) à (RSi-p) correspond aux valeurs de médianes (Med$_1$, Med$_2$) et à la plage de classification (P$_1$, P$_2$) défini par l'écart des bornes de classification B-A et D-C pour chaque unités traitement statistique (81_G), (81_D), (81_S), et (81_P). Soit pour (RSi-1) et (RSi-2), respectivement les médianes du mode globale (MedG$_1$, MedG$_2$) et leur plages respectives (PG$_1$, PG$_2$), de même pour le mode dynamique, structurale et leur position (MedP$_1$, MedP$_2$) correspondant au barycentre énergétique et (PP$_1$, PP$_2$) à son étendu. Dans cet exemple l'unité de registres de sortie (76) comporte les registres (RSi-1) à (RSi-8). En général un certain nombre de registres (RSi-x) ne sont pas exploités car non pertinent. Par exemple la perception visuelle d'un texte a un mode global uniforme (même couleurs et non déplacement), seul l'aspect structurant apporte une information pertinente. Des huit registres de départ, il ne reste que trois : barycentre, dimension et structure.
- Une unité de registres d'entrée (77) comporte les registres (RSo-1) à (RSo-q) représentant la même organisation que celle de l'unité de registres de sortie (76). Soit pour (RSo-1) et (RSo-2) respectivement les médianes du mode globale (MedG$_1$, MedG$_2$) et leur plages respectives (PG$_1$, PG$_2$), qui sont transformés en bornes de classification A, B, C, D tel que la borne A soit égale à MedG$_1$ - PG$_1$/2, la borne B à MedG$_2$ + PG$_2$/2, de même pour les bornes C et D dans le même ordre.. Ces bornes A, B, C, D de classification sont écrites dans l'unité de classification de requête (84). La même opération est répétée pour les autres unités de classification de requête (84) des unités (81_D), (81_S) et (81_P). Pour une information de z bits plus grand que quatre bits, il est préférable d'étendre la plage de classification en diminuant la borne basse de classification d'une valeur de 1 à 2 bits et en augmentant la borne haute de classification d'une valeur de 1 à 2 bits afin d'élargir la requête.

**la Mémoire Associative (10)**

L'unité Mémoire Associative (10), décrit dans les figures précédentes, dans sa mise en oeuvre générique a pour interface avec les unités attracteurs dynamiques (80_1) à (80_n) le message (MEin_i) constitué de n sous-messages (RSin_1) à (RSin_n) et le message (MEout_j) constitué de n sous-messages (RSout_1) à (RSout_n).

Le sous-message (RSin_1) est transmis de l'unité de registres de sortie (76) de l'unité attracteur dynamique (80_1) au port d'entrée (In) de la sous-unité mémoire (1_1) de l'unité Mémoire Associative (10). De même, le sous-message (RSin_2) est transmis de l'unité de registres de sortie (76) de l'unité attracteur dynamique (80_2) au port d'entrée (In) de la sous-unité mémoire (1_2) de l'unité Mémoire Associative (10), et la transmission continue dans le même ordre jusqu'au rang n.

En inverse, le sous-message (RSout_1) est transmis du port de sortie (Out) de la sous-unité mémoire (1_1) de l'unité Mémoire Associative (10) à l'unité de registres d'entrée (77) de l'unité attracteur dynamique (80_1). De même, le sous-message (RSout_2) est transmis du port de sortie (Out) de la sous-unité mémoire (1_2) de l'unité Mémoire Associative (10) à l'unité de registres d'entrée (77) de l'unité attracteur dynamique (80_2), et la transmission continue dans le même ordre jusqu'au rang n.

L'unité Mémoire Associative (10) comporte en particulier :

- un premier ensemble composé de n sous-unités mémoires, composée chacune de $2^w$ mots de w bits, notées de (1_1) à (1_n), et recevant chacune sur leur port d'entrée (In) respectivement le sous-message (RSin_1) pour la sous-unité mémoire (1_1) jusqu'au sous-message (RSin_n) pour la sous-unité mémoire (1_n).
- un second ensemble se compose d'une sous-unité mémoire de $2^v$ mots de v bits (2) recevant sur le port d'entrée (In) le label (Lin_j).
- une unité de calcul de maximum de vraisemblance (4) afin de sélectionner la valeur i, k ou autre la plus représentée. Cette unité (4) reçoit du port de sortie (Cadr) de chaque sous-unité mémoire (1_1) à (1_n) une valeur i, ou autre k respectivement sur un port entré (L_i) à (L_n) avec leur signal binaire respectif de validation sur l'entré respectivement (V_1) à (V_n). Le séquencement interne est assuré par un signal horloge (CK) introduit dans l'unité (4). Le choix du maximum de vraisemblance est positionné sur le port de sortie (L_i), un bus de v bits transmet cette valeur au port entrée (Adr) de la sous-unité mémoire (2) qui délivre sur son port de sortie (Out) la valeur du label (Lout_i).

Dans le sens label vers message, le procédé est identique à celui décrit à la **figure** 3. La présentation de (Lin_j) sur le port entrée (In) de la sous-unité mémoire (2) entraine la délivrance de la valeur j sur son port de sortie (Cadr), cette valeur j est transmise au bus AB au travers d'une unité de choix de valeur de lien (5) et est présentée à toutes les sous-unités mémoire (1_1) à (1_n) qui délivre chacune sur son port de sortie (Out) le sous-message respectivement (RSout_1) à (RSout_n) qui, ensemble, forme le message (MEout_j).

Dans le sens inverse, message vers label, les sous-messages (RSin_1) à (RSin_n), correspondant au message (MEin_i), sont présentés respectivement sur le port entrée (In) de chaque sous-unité mémoire (1_1) à (1_n) qui délivrent chacune une valeur i, ou autre k sur leur port de sortie (Cadr) respectif en association à un signal binaire de validation débité par la sortie (M) de la même sous-unité mémoire. Dans le cas où le sous-message présenté est absent de la sous-unité mémoire, celle-ci délivre sur sa sortie (M) un signal binaire de non validation, la valeur présente sur son port de sortie (Cadr) est alors ignorée.

**Décomposition des messages.**

Chaque message reçu (MEin) de n.w bits est composé de n sous-messages (RSin_x) de w bits, x variant de 1 à n. De même chaque message (MEout) de n.w bits délivré par la Mémoire Associative est composé de n sous-messages (RSout_x) de w bits, x variant de 1 à n.

Chaque sous-message est découpé en q éléments (RSi_x) entrant ou (RSo_x) sortant de z bits correspondant à w/q bits dont le rang de l'élément correspond à une notion de position, dimensionnement et de caractérisation.

- La position est définie par son référentiel (Ref), variant généralement de un à trois, souvant égale à deux pour un couple d'éléments par exemple x et y représentant une relation entre deux distances dans le référentiel (Ref), ou t et f représentant une relation entre temps et fréquence dans le référentiel (Ref). D'une manière générale, c'est la position du barycentre du nuage de données représentant la caractérisation ci-dessus défini par ses éléments du sous-message.
- Le dimensionnement caractérise l'étendue du nuage de données, généralement sa dimension, donc un élément (RSi_x), dans chacun des axes du référentiel (Ref).

- La caractérisation est généralement une représentation sémantique élémentaire de type :

  - Globale, par exemple non limitatif, une couleur est définie par une teinte et une saturation, une voix d'enfant est définie par un fondamental, etc.
  - Dynamique, par exemple non limitatif, un mouvement est défini par sa vitesse et son orientation, c'est aussi la prosodie d'une voix, etc.
  - Structurelle, par exemple non limitatif, un bord est défini par son orientation et sa courbure, un phonème est défini par la répartition de ses formants dans le temps, etc.

Le label se compose d'un mot de v bits, la quantité de labels mémorisable est de $2^v-1$, le label « zéro » étant exclu.

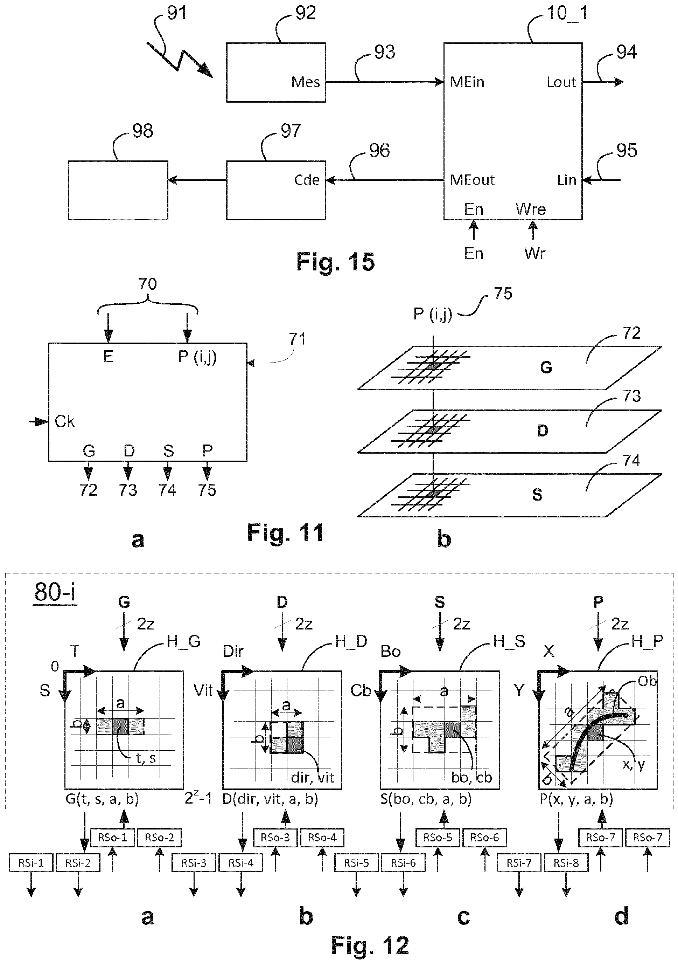

La définition du label est donnée par le message entrant qui peut être incomplet et/ou erroné, d'où une difficulté de retrouver le label. L'utilisation d'un mode ternaire sur certains éléments (RSi_x), correspondant à masque d'un champ de bits appliqué à une partie du message d'entrée (17) de (RSin_i), permet de résoudre ce problème. La **figure 11-a** explicite le fonctionnement de l'unité de transfert de traduction (71) à partir des données spatio-temporelles (70) (Données temporelles E et position P(i,j)) issues d'un capteur externe, non représenté. Chaque donnée spatio-temporelles (70) entrante dans cette unité (71) est traduite et délivrée sur quatre ports de sortie, d'une manière synchrone par un signal Ck, en trois représentations sémantiques élémentaires distinctes, G, D, S, positionnées en P. Chaque port de sortie G, D, S, et P est connecté indépendamment et respectivement, sur le bus G (72), le bus D (73), le bus S (74) et le bus P (75).

La **figure 11-b** est une représentation imagée des différentes données G, D, S, et P. La donnée entrante est représentée dans son mode global sortie G, dynamique sortie D, et structural sortie S, et en position i,j déterminée par la donnée P, suivant trois plans registrés en mode 2D. La position P est exprimée en fonction de la dimension de sa base. Généralement 2D pour des données visuelles (x, y) ou auditives (t, f), elle peut être étendue à du 3D ou réduite à 1 D.

La **figure 12** illustre l'organisation des résultats des calculs des quatre histogrammes bilinéaires de l'unité attracteur dynamique (80_i) à partir des données de 2z bits G, D, S, et P issues de l'unité de transfert de traduction (71). La donnée entrante traitée dans cet exemple est de type vision 2D. L'unité (71) traduit cette donnée en

- représentation globale (G) : suivant deux axes, teinte (T) et saturation (S). Histogramme (H_G) sur $2^{2z}$ valeurs, **figure 12a.**
- représentation dynamique (D) : suivant deux axes, direction (Dir) et vitesse de déplacement (Vit). Histogramme (H_D) sur $2^{2z}$ valeurs, **figure 12b.**
- représentation structurale (S) : suivant deux axes, bord orienté (Bo) et courbure (Cb). Histogramme (H_S) sur $2^{2z}$ valeurs, **figure 12c.**
- représentation en position (P) : suivant deux axes x et y. Histogramme (H_P) sur $2^{2z}$ valeurs, **figure 12d.**

Chaque donnée entrante est codée en mot de 2z bits donnant une représentation matricielle $2^z \times 2^z$ du calcul d'histogramme, les z bits premiers représentant un axe et les z bits restant le second axe de la matrice.

Pour illustrer le procédé perceptif de représentations sémantiques élémentaires, une portion de bord d'un objet (Ob) est visualisée en **figure 12d** par sa représentation en position (P), valeurs grisées correspondant aux résultats classés, par l'unité de classification (83), du calcul d'histogramme bilinéaire de la matrice (H_P). Le résultat de ce calcul d'histogramme est transmis à l'unité de registres de sortie (76) avec pour valeur, son barycentre en position de 2z bits (x, y) et sa plage en dimension de 2z bits (a, b).

L'orientation et la courbure locale perçu de l'objet (Ob), **figure 12c,** est délivré par le calcul de l'histogramme bilinéaire (H_S) dont le résultat du calcul est transmis à l'unité de registres de sortie (76) avec pour valeur, son barycentre, donc sa représentation sémantique d'orientation et de courbure de 2z bits (bo, cb) et sa tolérance de 2z bits (a, b).

La **figure 12a** indique, par le résultat du calcul d'histogramme bilinéaire (H_G) la couleur dominante de la partie de l'objet (Ob) représentée par sa valeur de teinte et de saturation de 2z bits (t, s) avec sa valeur de tolérance de 2z bits (a, b), transmis à l'unité de registres de sortie (76).

De même la **figure 12b** indique, par le résultat du calcul d'histogramme bilinéaire (H_D) le déplacement local de la partie de l'objet (Ob) représenté par sa valeur de direction de mouvement et sa vitesse de 2z bits (t, s) avec sa valeur de tolérance de 2z bits (a, b), transmis à l'unité de registres de sortie (76).

En inverse, l'unité de registres d'entrée (77) actualise, dans le même ordre, les bornes de classification des unités de classification requête (84) de chaque unité de traitement statistique (81 _G, 81_D, 81 _S, et 81_P).

Ce procédé perceptif assure un asservissement entre les données perçues, représentées et interprétées en tant que label appris.

Dans cet exemple d'application, le sous-message entrant RSin_x) de la Mémoire Associative (10) est composé des résultats (t, s, a, b) pour le sous message (RSi-1) et (RSi-2), (dir, vit, a, b) pour le sous message (RSi-3) et (RSi-4), (bo, cb, a, b) pour le sous message (RSi-5) et (RSi-6), et (x, y, a, b) pour le sous message (RSi-7) et (RSi-8). De même pour le sous message sortant (RSout_x) de la Mémoire Associative (10).

Ce sous-message (RSin_x) est une représentation sémantique élémentaire globale, dynamique, structurale et positionnée. Les n sous-messages (RSin_x), x variant de 1 à n, définissent le message MEin_i représentant en sortie de la Mémoire Associative (10) le label (Lout_i).

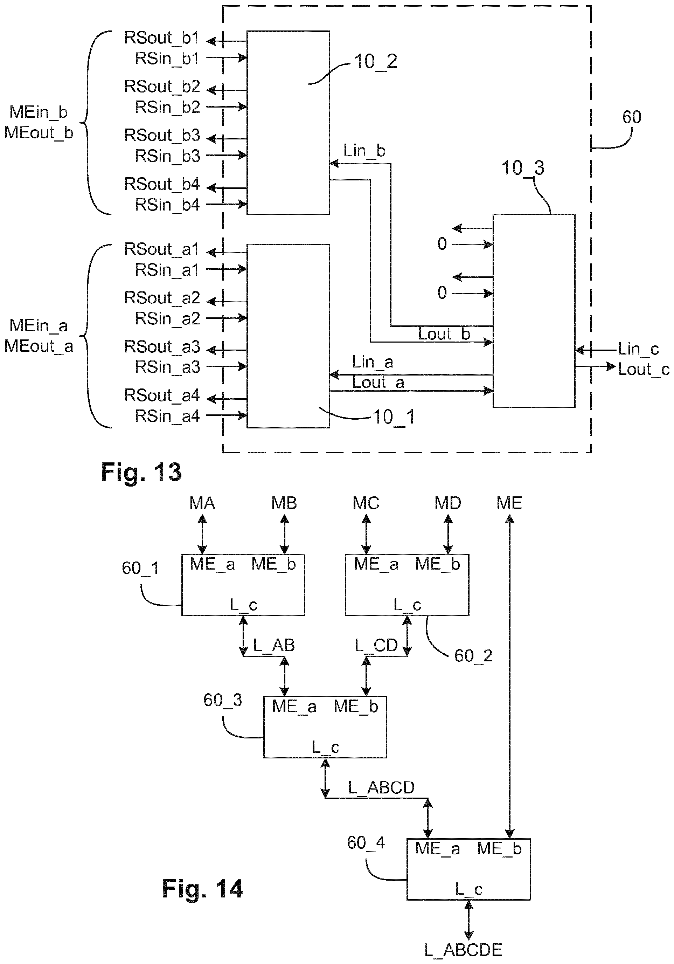

La **figure 13** représente une utilisation de trois unités Mémoire Associative (10_1) à (10_3) regroupées en un ensemble associatif de messages (60) versus label et vice versa, ayant chacune une organisation du message en quatre sous-messages, assemblées en deux niveaux hiérarchiques associant en parallèle deux messages entrant (MEin_a) et (MEin_b) à un label sortant (Lout_c) et un label entrant (Lin_c) à deux messages sortant (MEout_a) et (MEout_b). Le message (MEin_a) se compose de quatre sous-messages (RSin_a1) à (RSin_a4) en entrée de l'unité (10_1), de même le message (MEout_a) se compose de quatre sous-messages (RSout_a1) à (RSout_a4), en sortie de l'unité (10_1). L'unité (10_2) possède la même configuration que l'unité (10_1), l'indice a étant remplacé par b. Les labels (Lout_a) et (Lout_b) forment le message intrant de l'unité (10_3), de même les labels entrant (Lin_a) et (Lin_b) forment le message sortant de l'unité (10_3). Cette unité (10_3) associe son label entrant (Lin-c) au message sortant, constitué des sous-messages (Lin_a) et (Lin_b), et son label sortant (Lout-c) au message entrant, constitué des sous-messages (Lout_a) et (Lout_b). Les sous-messages non présent en entrée de l'unité (10_3) sont représentés par la valeur zéro.

Cet agencement de trois unités Mémoire Associative (10_1) à (10_3) permet d'associer les messages (MEin_a) et (MEin_b) au label (Lout_c) et vice versa les messages (MEout_a) et (MEout_b) au label (Lin_c).

Cet agencement est non limitatif, il peut être étendu en nombres d'unités Mémoire Associative (10_1) à (10_x) et regroupées suivant plusieurs niveaux hiérarchiques, les messages étant alors de taille variables en nombre de sous-messages. Ces arborescences permettent des apprentissages complexes et variés avec un nombre d'unité Mémoire Associative (10_1) à (10_x) restreint.

Par exemple un message (A) représentant le chiffre un et un message (B) représentant le chiffre zéro sont associés respectivement à l'unité mémoire associative (10_1) et l'unité mémoire associative (10_2), ces unités délivrent respectivement les labels « un » et « zéro » qui forment le nouveau message pour une unité mémoire associative (10_3) qui délivre un label « dix ». Dans le sens inverse, le label « dix » génère un message comportant deux sous messages de label « un » et « zéro » qui sont introduit respectivement dans les unités mémoire associative (10_1) et (10_2) et qui génère respectivement les représentations élémentaires des chiffres « un » et « zéro », une partie de message erroné est corrigée.

De même, avec cette organisation, un message 1 associe un (son) avec une unité mémoire associative (10_1), et un message 2 associe un (oiseau blanc) avec une unité mémoire associative (10_2), la troisième unité mémoire associative (10_3) associe le label « mouette ». En inverse l'écoute du son spécifique de la mouette est perçue en tant que représentations sémantiques élémentaires décrit par le message 1 qui est introduit dans l'unité mémoire associative (10_1) et en fourni un label son à l'unité mémoire associative (10_3), son unité de maximum de vraisemblance (3) en déduit le label « mouette ». En retour cette même unité mémoire associative (10_3) génère le message (son) et (oiseau blanc). Le sous message oiseau blanc est introduit en tant que label dans l'unité mémoire associative (10_2) qui en débite un message de représentations sémantiques élémentaires correspondant à la description de cet oiseau afin de le repérer.

La **figure 14** représente une extension et généralisation de l'utilisation de plusieurs ensembles associatifs de messages versus label et vice versa en tant que générateur universel de graphe hiérarchique (60). Pour plus de clarté, les signaux binaires de commande (En), (Wr), (T), (Cor), et son horloge de séquencement (Ck) gérant l'ensemble des Mémoire Associative (10) de ces ensembles (60) sont non représentés.

Un premier ensemble associatif de messages (60_1) associe deux messages (A) et (B) à un label (L_AB) et vice versa. Un second ensemble associatif de messages (60_2) associe deux messages (C) et (D) à un label (L_CD) et vice versa. Un troisième ensemble associatif de messages (60_3) associe les deux labels définis précédemment en tant que messages (L_AB) et (L_CD) à un label (L_ABCD) et vice versa. Un quatrième ensemble associatif de messages (60_4) associe le label défini précédemment en tant que messages (L_ABCD) et le message (E) à un label (L_ABCDE) et vice versa.

La **figure 15** explicite un mode d'utilisation type robotique. Un stimulus (91) est perçu par un récepteur (92) qui émet alors sur son port de sortie (Mes) un message afférent (93) vers l'unité Mémoire Associative (10_1) sur son entrée (MEin) entrainant sur sa sortie (Lout) une information de sortie label perçu (94). Un processus d'analyse, ici non représenté, en déduit en fonction de l'application mise en oeuvre un label de commande (95) qui est délivré sur le port entrée (Lin) de la Mémoire Associative (10_1). Celle-ci débite alors sur son port de sortie (MEout) un signal efférent (96) qui est connecté au port d'entrée (Cde) de l'unité effecteur (97) qui donne la réponse (98).

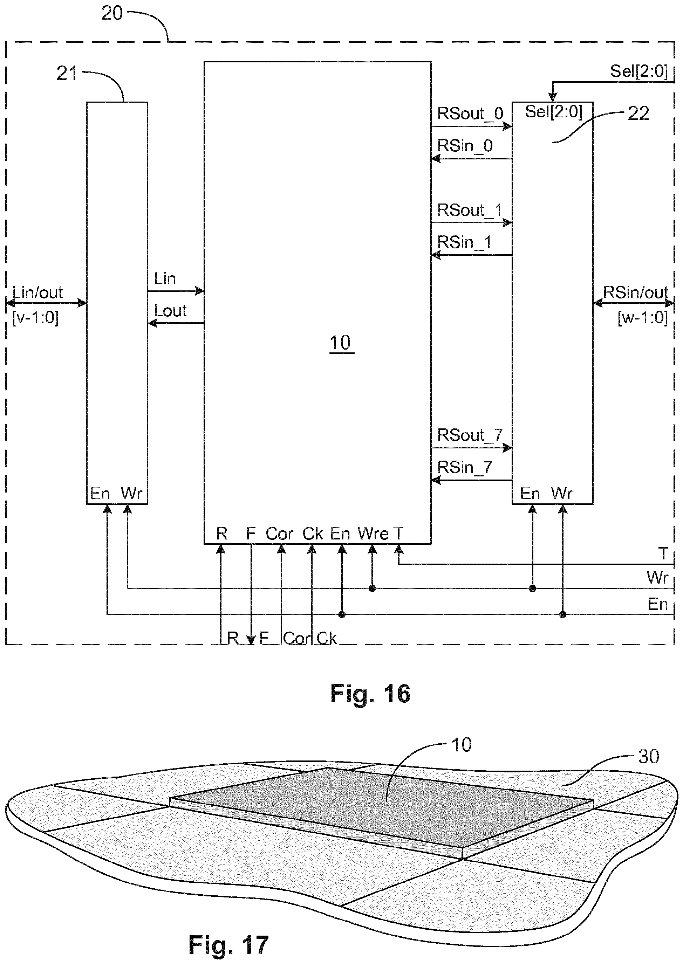

La **figure 16** représente un composant électronique (20) intégrant la mémoire associative (10). Afin de réduire le nombre de plots du circuit, sont associés :

- Une unité interface de communication (21) entre les entrées/sorties (Lin/Lout) de la mémoire associative et le port bidirectionnel (Lin/Lout) du composant électronique piloté par le signal (En) et (Wr).
- une interface de communication (22) entre les entrées/sorties (RSin_i/RSout_i) de la mémoire associative, sélectionnées par les signaux (Sel[2 :0]), et le port bidirectionnel (RSin/RSout) du composant électronique.
- Des signaux de commande : (En), (Wr), (T), (R), (F), (Cor), (Ck), et (Sel[2 :0]).

En prenant comme taille de bus : v=16 et w=24, le boitier comporte 56 plots ce qui est très compact. En dimensionnant n à 8, le volume mémoire se compose de 8 unités de $2^{16}$ mots de 24 bits et une unité mémoire de $2^{16}$ mots de 16 bits soit un total de 13 631 488 cellules mémoires. La cellule élémentaire est aujourd'hui inférieure au $\mu m^2$, par exemple $10F^2$ en technologie 28 nm pour une cellule ferroélectrique, ce qui permet la réalisation d'un circuit de moins de 15 $mm^2$ donc très économique pour une mémoire associative de 65 535 labels.

La **figure 17** représente une autre forme d'intégration électronique directement sur le substrat du wafer (30) qui a déjà été traité suivant un autre procédé de gravure. Ce procédé, appelé BEOL pour en anglais *Back End Of Line,* permet la réalisation d'un seul composant qui intègre la partie perceptive et la partie mémoire associative. C'est un système en un circuit (*SoC system on chip*). Ce circuit peut être dupliqué en matrice afin de traiter en parallèle plusieurs modalités perceptives telles que la vision, l'audition, le toucher...etc. et d'augmenter la connaissance perceptive engendrée. Ce circuit SoC peut avantageusement être empilé sous un capteur imageur afin de réaliser un capteur visuel doué d'intelligence. En y joignant une unité de transmission, il ne reste plus que l'alimentation à fournir pour le fonctionnement d'un produit complet.

**Référence nombres et symboles**

| | |
|---|---|
| **1_i** | Sous-unité (i) mémoire associative de $2^v$ mots de w bits |
| **2** | sous-unité mémoire associative de $2^v$ mots de v bits |
| **3** | unité de comptage de $2^v$ valeurs de (Cpt) avec entrée (R) de remise à zéro et sorte (F) de limite de comptage |
| **4** | unité de sélection de maximum de vraisemblance |
| **5** | unité multiplexeur 2 vers 1 à v bits |
| **6** | unité d'initialisation des sous-unités mémoires |
| **7** | unité booléenne OU booléen à 2 entrées |
| **7'** | unité booléenne ET-OU booléen à 2 entrées |
| **8** | unité booléenne OU booléen à 2 entrées |
| **9** | unité booléenne ET booléen à 2 entrées dont une inversée à v bits |
| **10** | unité Mémoire Associative |
| **11_i** | unité (i) booléenne ET booléen à 2 entrées dont une inversée à w bits |
| **12** | unité multiplexeur 2 vers 1 à v bits |
| **13** | unité booléenne OU booléen à 2 entrées |
| **14** | unité multiplexeur 2 vers 1 à 1 bit |
| **15** | unité booléenne OU booléen à 2 entrées |
| **16** | unité booléenne ET booléen à 2 entrées |
| **17** | masque d'un champ de bits appliqué à une partie du message d'entrée RSin_i |
| **20** | composant électronique intégrant la mémoire associative (10) |
| **21** | interface de communication entre les entrées/sorties Lin/Lout de la mémoire associative (10) et le composant électronique (20) |
| **22** | interface de communication entre les entrées/sorties RSin_i/RSout_i de la mémoire associative (10) et RSin/RSout du composant électronique (20) |
| **30** | wafer silicium |
| **41** | unité de séquencement et quantification des données avec recherche de la donnée la plus représentée |
| **42** | registre de quantification de la donnée la plus représentée |
| **43** | valeur de sortie de l'unité de sélection de maximum de vraisemblance |
| **50** | unité de choix de position |
| **51** | unité séquenceur |
| **52** | unité multiplexeur à n entrées de w bits |
| **60** | générateur universel de graphe hiérarchique |
| **70** | donnée spatio-temporelle entrante |
| **71** | unité de transfert de traduction |
| **72** | bus G |
| **73** | bus D |

| | |
|---|---|
| **74** | bus S |
| **75** | bus P |
| **76** | unité de registres de sortie |
| **77** | unité de registres d'entrée |
| **78** | signal binaire de validation de calcul d'histogramme |
| **80** | unité attracteur dynamique |
| **81_G, 81_D, 81_S, et 81_P** | unités traitement statistique |
| **82** | unité de calcul histogramme bilinéaire |
| **83** | unités de classification automatique |
| **84** | unités de classification requête |
| **85** | unité booléenne de validation de classification |
| **86** | unité booléenne de classification spatio-temporelle |
| **87** | unité de validation de calcul d'histogramme |
| **91** | stimulus |
| **92** | récepteur |
| **93** | voie afférente |
| **94** | label perçu |
| **95** | label de commande |
| **96** | voie efférente |
| **97** | effecteur |
| **98** | réponse |
| **AB** | bus commun de v bits |
| **Adr** | port entrée adresse mémoire des sous-unités mémoire (1_1) à (1_n) et (2) |
| **Cadr** | port de sortie adresse du contenu mémoire sélectionné par son port entrée (In) des sous-unités (1_1) à (1_n) et (2) |
| **Cin** | commande entrée inhibition dynamique |
| **Cout** | commande sortie inhibition dynamique |
| **Ck** | horloge de séquencement |
| **Cor** | entrée signal de commande de correction du message d'entrée (RSin_i) |
| **Cpt** | port de sortie de l'unité de comptage (3) |
| **Cpt[v-1 :0]** | valeur binaire de sortie de l'unité de comptage (3) |
| **D** | représentation sémantique élémentaire dynamique |
| **En** | entrée validation fonction des sous-unités mémoires associatives (1_i) et (2) |
| **F** | sortie signal de limite de comptage |
| **G** | représentation sémantique élémentaire globale |
| **In** | port d'entrée des sous-unités mémoire (1_1) à (1_n) et (2) |
| **L_i** | valeur de lien entre les mémoires (1) et (2) |
| **L_AB** | label entrant et sortant |
| **L_CD** | label entrant et sortant |
| **Lout_i** | Label en sortie |
| **Lin_j** | Label en entrée |
| **M** | signal en sortie validant la valeur binaire du port de sortie (Cadr) associée |
| **MA, MB, MC, MD, ME** | messages entrant et sortant |
| **MEin_i** | message entrant regroupant n sous-messages (RSin_1) à (RSin_n) |
| **MEout_j** | message sortant regroupant n sous-messages (RSout_1) à (RSout_n) |
| **n** | nombre de sous-messages entrée (RSin_i) ou sortie (RSout_i) |
| **Ob** | portion de bord d'un objet |
| **Out** | port de sortie des sous-unités mémoire (1_1) à (1_n)) et (2) |
| **P** | position des représentations sémantiques élémentaires G, D, et S |
| **q** | nombre d'éléments constituant un sous-message |
| **R** | entrée signal de remise à zéro de l'unité de comptage (3) |
| **S** | représentation sémantique élémentaire structurale |
| **Wr** | signal de commande écriture des sous-unités mémoires (1) et (2) |
| **Wre** | entrée signal de sélection écriture de l'unité Mémoire Associative (10) |
| **RSi_x** | élément du sous message entrant RSin_i de z bits |
| **RSo-x** | élément du sous message sortant RSout i de z bits |
| **RSin_i** | sous-message (i) en entrée mémoire |
| **RSout_i** | sous-message (i) en sortie mémoire |

| V_i | entrée validation valeur (L_i) |
| --- | --- |
| **Wr** | signal de commande écriture des mémoires (1) et (2) |
| **/1** | signal binaire de 1 bit |
| **/v** | bus signal binaire de v bit |
| **/w** | bus signal binaire de w bit, w=z.q |
| **/z** | bus signal binaire de z bit |

**Revendications**

1. Unité de mémorisation associative (10) comprenant :

- au moins une première sous-unité mémoire (1_1 à 1_n) comprenant chacune $2^v$ mots de w bits, l'au moins une première sous-unité mémoire formant un premier ensemble de n sous-unités mémoires, n étant supérieur ou égal à 1 ;
- une seconde sous-unité mémoire (2) comprenant $2^v$ mots de v bits formant un second ensemble ;

chaque sous-unité mémoire comprenant :

- $2^v$ positions mémoires pour stocker les mots, chaque position étant identifiée par un adresse mémoire sur v bits ;
- un port d'entrée d'adresses mémoire (Adr) de v bits ;
- un port d'entrée de données (In) de v ou w bits et ;
- un port de sortie des données (Out) de v ou w bits ;
- un port de sortie d'adresses mémoire (Cadr) de v bits ;
- une sortie binaire de validation du contenu (M) ;

chaque sous-unité mémoire étant configurée :

- dans un mode écriture, pour enregistrer le mot reçu par le port d'entrée de données (In) à l'adresse reçue par le port d'entrée d'adresses mémoire (Adr) ;
- dans un mode lecture :

   - si une des $2^v$ positions mémoires contient le mot reçu par le port de données entrée (In), pour valider le signal binaire de sortie de validation du contenu présent (M), et délivrer l'adresse de la position sur port de sortie d'adresses mémoire (Cadr) ;
   - sinon, pour ne pas valider le signal binaire de sortie de validation du contenu (M).

ladite unité de mémorisation associative comprenant :

- un premier bus (AB), actif en mode lecture et écriture ;
- un deuxième bus, indépendant du premier, actif en mode lecture.

ladite unité de mémorisation associative comprenant une unité de sélection du maximum de vraisemblance (4), et dans laquelle, en mode lecture :

- le premier bus (AB) est issu du port de sortie d'adresses mémoire (Cadr) de la seconde sous-unité mémoire (2) et connecté aux ports d'entrée d'adresses mémoire (Adr) de chacune des premières sous-unités mémoire du premier ensemble (1_1 à 1_n) ;
- le deuxième bus connecte la sortie de chacun des ports de sortie d'adresse mémoire (Cadr) et de signaux de sortie binaire de validation du contenu (M) de chacune des premières sous-unités mémoire (1_1 à 1_n) du premier ensemble à l' entrée de l'unité de sélection du maximum de vraisemblance (4) ;
- l'unité de sélection du maximum de vraisemblance (4) est configurée pour fournir en sortie la valeur la plus représentée (L_i) parmi des valeurs en entrée, cette valeur étant introduite dans le port d'entrée d'adresses (Adr) de la seconde sous-unité mémoire (2).

2. Unité de mémorisation associative selon la revendication 1, dans lequel chaque sous-unité mémoire comprend un port de commande recevant une horloge entrée binaire de séquencement (Ck), un signal d'entrée binaire de sélection de la mémoire (En) et un signal d'entrée binaire d'écriture (Wr) communs à toutes les sous-unités mémoire, et est configurée pour :

- activer le mode écriture lorsque le signal d'entrée binaire de sélection de la mémoire (En) et un signal d'entrée binaire d'écriture (Wr) sont activés ;
- activer le mode lecture lorsque le signal d'entrée binaire de sélection de la mémoire (En) est activé, et le signal d'entrée binaire d'écriture (Wr) est inactif.

3. Unité de mémorisation associative selon l'une des revendications 1 à 2, dans laquelle, en mode lecture :

- le deuxième bus est connecté entre les ports de sortie d'adresses mémoire (Cadr) de l'au moins une première sous-unité mémoire (1_1 à 1_n) et le port d'entrée d'adresses mémoire (Adr) de la seconde sous-unité mémoire (2) ;
- le premier bus (AB) est connecté entre le port de sortie d'adresses mémoire (Cadr) de la deuxième sous-unité mémoire (2) et les ports d'entrée d'adresses mémoire (Adr) de l'au moins une première sous-unité mémoire (1_1 à 1_n).

4. Unité de mémorisation associative selon l'une des revendications 1 à 3, dans laquelle, en mode écriture, le premier bus (AB) est issu de la sortie d'un compteur binaire (3) de v bits génère un comptage de $2^v$ valeurs, et est connecté au port d'entrée d'adresses mémoire (Adr) de chaque sous-unité mémoire (1_1 à 1_n et 2).

5. Unité de mémorisation associative selon la revendication 2, dans laquelle, en mode écriture, le premier bus (AB) est issu de la sortie d'un compteur binaire (3) de v bits génère un comptage de $2^v$ valeurs, et est connecté au port d'entrée d'adresses mémoire (Adr) de chaque sous-unité mémoire (1_1 à 1_n et 2),

ladite unité de mémorisation associative comprenant:

- une unité d'initialisation (6) des sous-unités mémoire;
- un port de commande recevant en entrée un signal binaire d'entrées d'initialisation (Ini) et le signal d'entrée binaire de sélection de la mémoire (En) ;

dans laquelle, l'activation du signal d'entrée binaire d'entrées d'initialisation (Ini) est transmise à l'unité d'initialisation (6) et génère, conjointement à l'activation du signal d'entrée binaire de sélection de la mémoire (En), une phase d'initialisation dans laquelle l'unité d'initialisation (6) est configurée, afin d'initialiser à zéro toutes les positions mémoire de chaque sous-unité mémoire, pour:

- initialiser à zéro le compteur binaire (3) ;
- activer le signal d'entrée binaire d'écriture (Wr) pour valider le mode écriture;
- forcer à zéro le port d'entrée des données (In) de chaque sous-unité mémoire ;
- incrémenter le compteur binaire (3) d'une unité à chaque cycle de l'horloge entrée binaire de séquencement (Ck) pendant $2^v + 1$ cycles.

6. Unité de mémorisation associative selon la revendication 5, dans laquelle, hors de la phase d'initialisation, si le signal d'entrée binaire de sélection de la mémoire (En) est validé, le compteur binaire (3) est incrémenté à chaque validation du signal d'écriture mémoire (Wr).

7. Unité de Mémorisation Associative selon la revendication 4, dans laquelle le compteur binaire (3) est initialisé à zéro puis incrémenté d'une unité par la commande d'un signal binaire de transfert (T), définissant un cycle de transfert, au cours duquel l'unité de Mémorisation Associative délivre en sortie un label (Lout_i) et un message (MEout_i) associés à la valeur du compteur (i).

8. Unité de Mémorisation Associative selon l'une des revendications 1 à 7, **caractérisée en ce que**, lorsqu'un signal entrée binaire de correction (Cor) en mode lecture est validé, les informations transmises dans le premier bus (AB) sont issues de la sortie (L_i) de l'unité de sélection de la valeur du maximum de vraisemblance (4).

9. Unité de Mémorisation Associative selon la revendication 4, dans laquelle, en mode écriture, la valeur du compteur binaire (3) est incrémentée d'une unité en début d'une d'écriture afin de fournir une valeur correspondante à la nouvelle adresse sur le premier bus (AB).

**10.** Unité de Mémorisation Associative selon la revendication 4, comprenant le regroupement du premier ensemble de sous-unités mémoires (1_1 à 1_n), du deuxième ensemble de sous-unités mémoire (2), du compteur binaire (3), de l'unité de calcul du maximum de vraisemblance (4), l'unité d'initialisation (6), et un ensemble d'éléments logique de contrôle, ladite unité de contrôle formant une unité de base de la Mémorisation Associative (10).

**11.** Unité de Mémorisation Associative selon la revendication 10, associant, en mode lecture un message entrant (MEin_i) constitué de n sous-messages entrants (RSin_1 à RSin_n) indépendants de w bits en entrée à un label sortant (Lout_j) de v bits en sortie et, un label entrant (Lin_i) de v bits à un message sortant (MEout_j) constitué de n sous-messages sortants (RSout_1 à RSout_n) indépendants de w bits et dans laquelle :

   - chacun des ports d'entrée de données (In) des premières sous-unités mémoire du premier ensemble reçoit respectivement un sous-message entrant (RSin_1 à RSin_n) de w bits ;
   - chacun des ports d'entrée de sortie (Out) des premières sous-unités mémoire du premier ensemble émet respectivement un sous-message sortant (RSout_1 à RSout_n) ;
   - le port d'entrée de données de la seconde sous-unité mémoire reçoit le label entrant (Lin_i) ;
   - le port de données de sortie de la seconde sous-unité mémoire émet le label sortant (Lout_i).

**12.** Unité de Mémorisation Associative selon la revendication 11, **caractérisé en ce que** chaque sous-message entrant (RSin_x) et sortant (RSout_x) de w bits est structuré en p éléments de w/p bits avec, pour chaque élément, une définition propre à son emplacement.

**13.** Dispositif de Mémorisation Associative, comprenant une unité de Mémorisation Associative (10) selon l'une des revendications 11 à 12.

**14.** Dispositif de Mémorisation Associative selon la revendication 13 comprenant :

   - au moins un attracteur dynamique (80_x) ayant une unité de registres d'entrée (77) et une unité de registres résultat (76) ;

   dans lequel un sous-message sortant (RSout_x) de w bits de l'unité de mémorisation associative (10) est délivré à l'unité de registre d'entrée (77) de l'attracteur dynamique, et qu'un sous-message entrant (RSin_x) de w bits de l'unité de mémorisation Associative (10) est délivré par l'unité de registres résultat (76) de l'attracteur dynamique.

**15.** Procédé de Mémorisation Associative par une unité de mémorisation associative (10) comprenant :

   - au moins une première sous-unité mémoire (1_1 à 1_n) comprenant chacune $2^v$ mots de w bits, l'au moins une première sous-unité mémoire formant un premier ensemble de n sous-unités mémoires n étant supérieur ou égal à 1;
   - une seconde sous-unité mémoire (2) comprenant $2^v$ mots de v bits formant un second ensemble ;
   chaque sous-unité mémoire comprenant :

      - $2^v$ positions mémoires pour stocker les mots, chaque position étant identifiée par un adresse mémoire sur v bits ;
      - un port d'entrée d'adresses mémoire (Adr) de v bits ;
      - un port d'entrée de données (In) de v ou w bits et ;
      - un port de sortie des données (Out) de v ou w bits ;
      - un port de sortie d'adresses mémoire (Cadr) de v bits ;
      - une sortie binaire de validation du contenu (M) ;

   ledit procédé comprenant :

      - dans un mode écriture, l'enregistrement du mot reçu par le port d'entrée de données (In) à l'adresse reçue par le port d'entrée d'adresses mémoire (Adr) ;
      - dans un mode lecture :

         - si une des $2^v$ positions mémoires contient le mot reçu par le port de données entrée (In), la validation du signal binaire de sortie de validation du contenu présent (M), et la délivrance de l'adresse de la position sur port de sortie d'adresses mémoire (Cadr) ;

- sinon, la non-validation du signal binaire de sortie de validation du contenu (M).

ledit procédé comprenant :

- l'activation d'un premier bus (AB) de l'unité de mémorisation Associative en mode lecture et écriture ;
- l'activation d'un deuxième bus de l'unité de mémorisation Associative, indépendant du premier, en mode lecture ;

et dans lequel l'unité de Mémorisation Associative comprend une unité de sélection du maximum de vraisemblance (4), et, en mode lecture :

- le premier bus (AB) est issu du port de sortie d'adresses mémoire (Cadr) de la seconde sous-unité mémoire (2) et connecté aux ports d'entrée d'adresses mémoire (Adr) de chacune des premières sous-unités mémoire du premier ensemble (1_1 à 1_n) ;
- le deuxième bus connecte la sortie de chacun des ports de sortie d'adresse mémoire (Cadr) et de signaux de sortie binaire de validation du contenu (M) de chacune des premières sous-unités mémoire (1_1 à 1_n) du premier ensemble en entrée de l'unité de sélection du maximum de vraisemblance (4) ;

et le procédé comprend :

- la fourniture, en sortie de l'unité de sélection du maximum de vraisemblance des valeurs en entrée, et l'introduction de cette valeur la plus représentée (L_i) dans le port d'entrée d'adresses (Adr) de la seconde sous-unité mémoire (2).

**Patentansprüche**

1. Assoziative Speichereinheit (10), die Folgendes umfasst:

- mindestens eine erste Speicheruntereinheit (1_1 bis 1_n), die jeweils $2^v$ Wörter von w Bits umfasst, wobei die mindestens eine erste Speicheruntereinheit einen ersten Satz von n Speicheruntereinheiten bildet, wobei n gleich oder größer 1 ist;
- eine zweite Speicheruntereinheit (2) mit $2^v$ Wörtern von v Bits, die einen zweiten Satz bilden;
wobei jede Speicheruntereinheit Folgendes umfasst:

- $2^v$ Speicherpositionen zum Speichern der Wörter, wobei jede Position durch eine Speicheradresse über v Bits identifiziert wird;
- einen Speicheradresseneingangsport (Adr) von v Bits;
- einen Dateneingangsport (In) von v oder w Bits; und
- einen Datenausgangsport (Out) von v oder w Bits;
- einen Speicheradressenausgangsport (Cadr) von v Bits;
- einen binären Ausgang (M) zum Validieren des Inhalts;

wobei jede Speicheruntereinheit konfiguriert ist zum:

- in einem Schreibmodus, Registrieren des über den Dateneingangsport (In) empfangenen Worts an der über den Speicheradresseneingangsport (Adr) empfangenen Adresse;
- in einem Lesemodus:
- wenn eine der $2^v$ Speicherpositionen das über den Dateneingangsport (In) empfangene Wort enthält, Validieren des binären Ausgangssignals (M) zum Validieren des aktuellen Inhalts und Liefern der Adresse der Position an den Speicheradressenausgangsport (Cadr);
- andernfalls Nichtvalidieren des binären Ausgangssignals (M) zum Validieren des Inhalts,

wobei die assoziative Speichereinheit Folgendes umfasst:

- einen ersten Bus (AB), der im Lese- und Schreibmodus aktiv ist;
- einen zweiten Bus, unabhängig vom ersten, der im Lesemodus aktiv ist, wobei die assoziative Speichereinheit eine Maximum-Likelihood-Auswahleinheit (4) umfasst, und wobei im Lesemodus:

- der erste Bus (AB) vom Speicheradressenausgangsport (Cadr) der zweiten Speicheruntereinheit (2) ausgeht und mit den Speicheradresseneingangsports (Adr) jeder der ersten Speicheruntereinheiten des ersten Satzes (1_1 bis 1_n) verbunden ist;
- der zweite Bus den Ausgang jedes der Speicheradressenausgangsports (Cadr) und der binären Ausgangssignale (M) zum Validieren des Inhalts jeder der ersten Speicheruntereinheiten (1_1 bis 1_n) des ersten Satzes mit dem Eingang der Maximum-Likelihood-Auswahleinheit (4) verbindet;
- die Maximum-Likelihood-Auswahleinheit (4) zum Ausgeben des am meisten dargestellten Wertes (L_i) unter Eingangswerten konfiguriert ist, wobei dieser Wert in den Adresseneingangsport (Adr) der zweiten Speicheruntereinheit (2) eingegeben wird.

2.  Assoziative Speichereinheit nach Anspruch 1, wobei jede Speicheruntereinheit einen Steuerport umfasst, der einen binären Sequenzierungseingangstakt (Ck), ein binäres Speicherauswahleingangssignal (En) und ein binäres Schreibeingangssignal (Wr) empfängt, die allen Speicheruntereinheiten gemeinsam sind, und konfiguriert ist zum:

    - Aktivieren des Schreibmodus, wenn das binäre Speicherauswahleingangssignal (En) und ein binäres Schreibeingangssignal (Wr) aktiviert sind;
    - Aktivieren des Lesemodus, wenn das binäre Speicherauswahleingangssignal (En) aktiviert ist und das binäre Schreibeingangssignal (Wr) inaktiv ist.

3.  Assoziative Speichereinheit nach einem der Ansprüche 1 bis 2, wobei im Lesemodus:

    - der zweite Bus zwischen den Speicheradressenausgangsports (Cadr) der mindestens einen ersten Speicheruntereinheit (1_1 bis 1_n) und dem Speicheradresseneingangsport (Adr) der zweiten Speicheruntereinheit (2) geschaltet ist;
    - der erste Bus (AB) zwischen dem Speicheradressenausgangsport (Cadr) der zweiten Speicheruntereinheit (2) und den Speicheradresseneingangsports (Adr) der mindestens einen ersten Speicheruntereinheit (1_1 bis 1_n) geschaltet ist.

4.  Assoziative Speichereinheit nach einem der Ansprüche 1 bis 3, wobei im Schreibmodus der erste Bus (AB) vom Ausgang eines binären Zählers (3) von v Bits ausgeht, der eine Zahl von $2^v$ Werten erzeugt, und mit dem Speicheradresseneingangsport (Adr) jeder Speicheruntereinheit (1_1 bis 1_n und 2) verbunden ist.

5.  Assoziative Speichereinheit nach Anspruch 2, wobei im Schreibmodus der erste Bus (AB) vom Ausgang eines binären Zählers (3) von v Bits ausgeht, der eine Zahl von $2^v$ Werten erzeugt, und mit dem Speicheradresseneingangsport (Adr) jeder Speicheruntereinheit (1_1 bis 1_n und 2) verbunden ist,

    wobei die assoziative Speichereinheit Folgendes umfasst:

    - eine Initialisierungseinheit (6) der Speicheruntereinheiten;
    - einen Steuerport, der als Eingang ein binäres Initialisierungseingangssignal (Ini) und das binäre Speicherauswahleingangssignal (En) empfängt;

    wobei die Aktivierung des binären Signals für Initialisierungseingänge (Ini) zur Initialisierungseinheit (6) übertragen wird und zusammen mit der Aktivierung des binären Speicherauswahleingangssignals (En) eine Initialisierungsphase erzeugt, in der die Initialisierungseinheit (6) zum Initialisieren aller Speicherpositionen jeder Speicheruntereinheit auf Null konfiguriert ist zum:

    - Initialisieren des binären Zählers (3) auf Null;
    - Aktivieren des binären Schreibeingangssignals (Wr) zum Validieren des Schreibmodus;
    - Setzen des Dateneingangsports (In) jeder Speicheruntereinheit auf Null;
    - Inkrementieren des binären Zählers (3) bei jedem Zyklus des binären Sequenzierungseingangstakts (Ck) während $2^v + 1$ Zyklen um eins.

6.  Assoziative Speichereinheit nach Anspruch 5, wobei außerhalb der Initialisierungsphase, wenn das binäre Speicherauswahleingangssignal (En) validiert ist, der binäre Zähler (3) bei jeder Validierung des Speicherschreibsignals (Wr) inkrementiert wird.

7.  Assoziative Speichereinheit nach Anspruch 4, wobei der binäre Zähler (3) auf Null initialisiert und dann durch die Steuerung durch ein binäres Transfersignal (T) um eins inkrementiert wird, was einen Transferzyklus definiert, in dessen Verlauf die assoziative Speichereinheit ein Label (Lout_i) und eine Nachricht (MEout_i) ausgibt, die mit dem Wert des Zählers (i) assoziiert sind.

8. Assoziative Speichereinheit nach einem der Ansprüche 1 bis 7, **dadurch gekennzeichnet, dass**, wenn ein binäres Korrektureingangssignal (Cor) im Lesemodus validiert wird, die im ersten Bus (AB) übertragenen Informationen vom Ausgang (L_i) der Einheit zur Auswahl des Maximum-Likelihood-Werts (4) ausgehen.

9. Assoziative Speichereinheit nach Anspruch 4, wobei im Schreibmodus der Wert des binären Zählers (3) zu Beginn eines Schreibvorgangs um eins inkrementiert wird, um einen Wert entsprechend der neuen Adresse auf dem ersten Bus (AB) bereitzustellen.

10. Assoziative Speichereinheit nach Anspruch 4, die das Gruppieren des ersten Satzes von Speicheruntereinheiten (1_1 bis 1_n), des zweiten Satzes von Speicheruntereinheiten (2), des binären Zählers (3), der Maximum-Likelihood-Berechnungseinheit (4), der Initialisierungseinheit (6) und eines Satzes von Steuerlogikelementen umfasst, wobei die Steuereinheit eine Basiseinheit des assoziativen Speichers (10) bildet.

11. Assoziative Speichereinheit nach Anspruch 10, die im Lesemodus eine aus n unabhängigen Eingangsunternachrichten (RSin_1 bis RSin_n) von w Bits am Eingang bestehende Eingangsnachricht (MEin_i) mit einem Ausgangslabel (Lout_j) von v Bits am Ausgang und einem Eingangslabel (Lin_i) von v Bits mit einer aus n unabhängigen Ausgangsunternachrichten (RSout_1 bis RSout_n) von w Bits bestehenden Ausgangsnachricht (MEout_j) assoziiert, und wobei:

- jeder der Dateneingangsports (In) der ersten Speicheruntereinheiten des ersten Satzes jeweils eine Eingangsunternachricht (RSin_1 bis RSin_n) von w Bits empfängt;
- jeder der Ausgangseingangsports (Out) der ersten Speicheruntereinheiten des ersten Satzes jeweils eine Ausgangsunternachricht (RSout_1 bis RSout_n) ausgibt;
- der Dateneingangsport der zweiten Speicheruntereinheit das Eingangslabel (Lin_i) empfängt;
- der Ausgangsdatenport der zweiten Speicheruntereinheit das Ausgangslabel (Lout_i) ausgibt.

12. Assoziative Speichereinheit nach Anspruch 11, **dadurch gekennzeichnet, dass** jede Eingangs-(RSin_x) und Ausgangs-(RSout_x)-Unternachricht von w Bits in p Elemente von w/p Bits strukturiert ist, wobei für jedes Element eine eigene Definition seiner Position vorliegt.

13. Assoziative Speichervorrichtung, die eine assoziative Speichereinheit (10) nach einem der Ansprüche 11 bis 12 umfasst.

14. Assoziative Speichervorrichtung nach Anspruch 13, die Folgendes umfasst:

- mindestens einen dynamischen Attraktor (80_x) mit einer Eingangsregistereinheit (77) und einer Ergebnisregistereinheit (76);

wobei eine Ausgangsunternachricht (RSout_x) von w Bits der assoziativen Speichereinheit (10) an die Eingangsregistereinheit (77) des dynamischen Attraktors geliefert wird und eine Eingangsunternachricht (RSin_x) von w Bits der assoziativen Speichereinheit (10) von der Ergebnisregistereinheit (76) des dynamischen Attraktors geliefert wird.

15. Verfahren zum assoziativen Speichern durch eine assoziative Speichereinheit (10), das Folgendes umfasst:

- mindestens eine erste Speicheruntereinheit (1_1 bis 1_n), die jeweils $2^v$ Wörter von w Bits umfasst, wobei die mindestens eine erste Speicheruntereinheit einen ersten Satz von n Speicheruntereinheiten bildet, wobei n gleich oder größer 1 ist;
- eine zweite Speicheruntereinheit (2), die $2^v$ Wörter von v Bits umfasst, die einen zweiten Satz bilden;
wobei jede Speicheruntereinheit Folgendes umfasst:

- $2^v$ Speicherpositionen zum Speichern der Wörter, wobei jede Position durch eine Speicheradresse über v Bits identifiziert wird;
- einen Speicheradresseneingangsport (Adr) von v Bits;
- einen Dateneingangsport (In) von v oder w Bits; und

- einen Datenausgangsport (Out) von v oder w Bits;
- einen Speicheradressenausgangsport (Cadr) von v Bits;
- einen binären Ausgang (M) zum Validieren des Inhalts;

wobei das Verfahren Folgendes umfasst:

- in einem Schreibmodus, Speichern des über den Dateneingangsport (In) empfangenen Worts an der über den Speicheradresseneingangsport (Adr) empfangenen Adresse;
- in einem Lesemodus:
- wenn eine der $2^v$ Speicherpositionen das über den Dateneingangsport (In) empfangene Wort enthält, Validieren des binären Ausgangssignals (M) zum Validieren des aktuellen Inhalts und Liefern der Adresse der Position an den Speicheradressenausgangsport (Cadr);
- andernfalls Nichtvalidieren des binären Ausgangssignals (M) zum Validieren des Inhalts,

wobei das Verfahren Folgendes umfasst:

- Aktivieren eines ersten Busses (AB) der assoziativen Speichereinheit im Lese- und Schreibmodus;
- Aktivieren eines zweiten Busses der assoziativen Speichereinheit, unabhängig vom ersten, im Lesemodus,

und wobei die assoziative Speichereinheit eine Maximum-Likelihood-Auswahleinheit (4) umfasst, und wobei im Lesemodus:

- der erste Bus (AB) vom Speicheradressenausgangsport (Cadr) der zweiten Speicheruntereinheit (2) ausgeht und mit den Speicheradresseneingangsports (Adr) jeder der ersten Speicheruntereinheiten des ersten Satzes (1_1 bis 1_n) verbunden ist;
- der zweite Bus den Ausgang jedes der Speicheradressenausgangsports (Cadr) und der binären Ausgangssignale (M) zum Validieren des Inhalts jeder der ersten Speicheruntereinheiten (1_1 bis 1_n) des ersten Satzes mit dem Eingang der Maximum-Likelihood-Auswahleinheit (4) verbindet;

und das Verfahren umfasst:

- das Bereitstellen, am Ausgang der Maximum-Likelihood-Auswahleinheit (4), von Werten am Eingang, und das Einführen dieses am meisten dargestellten Wertes (L_i) in den Adresseneingangsport (Adr) der zweiten Speicheruntereinheit (2).

## Claims

1. An associative-memory-storage unit (10) comprising:

- at least one first memory sub-unit (1_1 to 1_n) each comprising $2^v$ words of w bits, the at least one first memory sub-unit forming a first set of n memory sub-units, with n greater than or equal to 1;
- a second memory sub-unit (2) comprising $2^v$ words of v bits forming a second set;
each memory sub-unit comprising:

- $2^v$ memory positions for storing the words, each position being identified by a memory address over v bits;
- a v-bit memory-address input port (Adr);
- a v- or w-bit data input port (In); and
- a v- or w-bit data output port (Out);
- a v-bit memory-address output port (Cadr);
- a binary output (M) for validating the content;

each memory sub-unit being configured:

- in a write mode, to store the word received via the data input port (In) at the address received via the memory-address input port (Adr);
- in a read mode:
- if one of the $2^v$ memory positions contains the word received via the data input port (In), to validate the binary output signal (M) for validating the present content, and to deliver the address of the position to the memory-address output port (Cadr);
- otherwise, to not validate the binary output signal (M) for validating the content.

said associative-memory-storage unit comprising:

- a first bus (AB), which is active in read and write mode;
- a second bus, which is independent of the first, and active in read mode, said associative-memory-storage unit comprising a unit (4) for selecting maximum likelihood, and wherein, in read mode:
- the first bus (AB) originates from the memory-address output port (Cadr) of the second memory sub-unit (2) and is connected to the memory-address input ports (Adr) of each of the first memory sub-units of the first set (1_1 to 1_n);
- the second bus connects the output of each of the memory-address output ports (Cadr) and binary output signals (M) for validating the content of each of the first memory sub-units (1_1 to 1_n) of the first set to the input of the unit (4) for selecting maximum likelihood;
- the unit (4) for selecting maximum likelihood is configured to output the most represented value (L_i) among input values, this value being introduced into the address input port (Adr) of the second memory sub-unit (2).

2. The associative-memory-storage unit according to claim 1, wherein each memory sub-unit comprises a command port that receives a sequencing binary input clock (Ck), a memory-selecting binary input signal (En) and a write binary input signal (Wr) that are common to all the memory sub-units, and is configured to:

- activate the write mode when the memory-selecting binary input signal (En) and a write binary input signal (Wr) are activated;
- to activate the read mode when the memory-selecting binary input signal (En) is activated, and the write binary input signal (Wr) is inactive.

3. The associative-memory-storage unit according to one of claims 1 to 2, wherein, in read mode:

- the second bus is connected between the memory-address output ports (Cadr) of the at least one first memory sub-unit (1_1 to 1_n) and the memory-address input port (Adr) of the second memory sub-unit (2);
- the first bus (AB) is connected between the memory-address output port (Cadr) of the second memory sub-unit (2) and the memory-address input ports (Adr) of the at least one first memory sub-unit (1_1 to 1_n).

4. The associative-memory-storage unit according to one of claims 1 to 3, wherein, in write mode, the first bus (AB) originates from the output of a v-bit binary counter (3) that generates a count of $2^v$ values, and is connected to the memory-address input port (Adr) of each memory sub-unit (1_1 to 1_n and 2).

5. The associative-memory-storage unit according to claim 2, wherein, in write mode, the first bus (AB) originates from the output of a v-bit binary counter (3) that generates a count of $2^v$ values, and is connected to the memory-address input port (Adr) of each memory sub-unit (1_1 to 1_n and 2),

the associative-memory-storage unit comprising:

- a unit (6) for initialising the memory sub-units;
- a command port that receives as input an initialisation-input binary signal (Ini) and the memory-selecting binary input signal (En);

wherein, the activation of the binary input signal for initialisation inputs (Ini) is transmitted to the initialising unit (6) and generates, conjointly with the activation of the memory-selecting binary input signal (En), an initialisation phase in which the initialising unit (6) is configured to initialise to zero all the memory positions of each memory sub-unit, to:

- initialise to zero the binary counter (3);
- activate the write binary input signal (Wr) to validate the write mode;
- force to zero the data input port (In) of each memory sub-unit;
- increment the binary counter (3) by one on each cycle of the sequencing binary input clock (Ck) during

$2^v + 1$ cycles.

6. The associative-memory-storage unit according to claim 5, wherein, outside of the initialisation phase, if the memory-selecting binary input signal (En) is validated, the binary counter (3) is incremented on each validation of the memory write signal (Wr).

7. The associative-memory-storage unit according to claim 4, wherein the binary counter (3) is initialised to zero then incremented by one on command by a transfer binary signal (T), thus defining a transfer cycle, in the course of which the associative-memory-storage unit outputs a label (Lout_i) and a message (MEout_i) that are associated with the value of the counter (i).

8. The associative-memory-storage unit according to one of claims 1 to 7, **characterised in that**, when a read-mode correcting binary input signal (Cor) is validated, the information transmitted to the first bus (AB) is delivered at the output (L_i) of the unit (4) for selecting the value of the maximum likelihood.

9. The associative-memory-storage unit according to claim 4, wherein, in write mode, the value of the binary counter (3) is incremented by one at the start of a write operation in order to provide a value corresponding to the new address over the first bus (AB).

10. The associative-memory-storage unit according to claim 4, comprising the group of the first set of memory sub-units (1_1 to 1_n), the second set of memory sub-units (2), the binary counter (3), the unit (4) for computing maximum likelihood, the initialising unit (6), and a set of logic control elements, said controlling unit forming a basic unit of the associative-memory-storage (10).

11. The associative-memory-storage unit according to claim 10, associating, in read mode, an input message (MEin_i) consisting of n independent input sub-messages (RSin_1 to RSin_n) of w input bits with an output label (Loutj) of v output bits and a v-bit input label (Lin_i) with an output message (MEoutj) consisting of n w-bit independent output sub-messages (RSout_1 to RSout_n) and wherein:

   - each of the data input ports (In) of the first memory sub-units of the first set respectively receives a w-bit input sub-message (RSin _1 to RSin_n);
   - each of the output input ports (Out) of the first memory sub-units of the first set respectively emits an output sub-message (RSout_1 to RSout_n);
   - the data input port of the second memory sub-unit receives the input label (Lin_i);
   - the output data port of the second memory sub-unit emits the output label (Lout_i).

12. The associative-memory-storage unit according to claim 11, **characterised in that** each w-bit input sub-message (RSin_x) and w-bit output sub-message (RSout_x) is structured into p elements of w/p bits with, for each element, a definition specific to its location.

13. An associative-memory-storage device, comprising an associative-memory-storage unit (10) according to one of claims 11 to 12.

14. The associative-memory-storage device according to claim 13, comprising:

   - at least one dynamic attractor (80_x) having an input-register unit (77) and a result-register unit (76);

   wherein a w-bit output sub-message (RSout_x) of the associative-memory-storage unit (10) is delivered to the input-register unit (77) of the dynamic attractor, and a w-bit input sub-message (RSin_x) of the associative-memory unit (10) is delivered by the result-register unit (76) of the dynamic attractor.

15. A method for associative memory storage by an associative-memory-storage unit (10), comprising:

   - at least one first memory sub-unit (1_1 to 1_n) each comprising $2^v$ words of w bits, said at least one first memory sub-unit forming a first set of n memory sub-units, n being greater than or equal to 1;
   - a second memory sub-unit (2) comprising $2^v$ words of v bits forming a second set;
   each memory sub-unit comprising:

- $2^v$ memory positions for storing the words, each position being identified by a memory address over v bits;
- a v-bit memory-address input port (Adr);
- a v- or w-bit data input port (In); and
- a v- or w-bit data output port (Out);
- a v-bit memory-address output port (Cadr);
- a binary output (M) for validating the content;

said method comprising:

- in a write mode, storing the word received via the data input port (In) at the address received via the memory-address input port (Adr);
- in a read mode:
- if one of the $2^v$ memory positions contains the word received via the data input port (In), validating the binary output signal (M) for validating the present content, and delivering the address of the position to the memory-address output port (Cadr);
- otherwise, not validating the binary output signal (M) for validating the content,

the method comprising:

- activating a first bus (AB) of the associative-memory unit in read and write mode;
- activating a second bus of the associative-memory unit, independently of the first, in read mode;

and wherein the associative-memory-storage unit comprises a unit (4) for selecting maximum likelihood, and, wherein in read mode:

- the first bus (AB) originates from the memory-address output port (Cadr) of the second memory sub-unit (2) and is connected to the memory-address input ports (Adr) of each of the first memory sub-units of the first set (1_1 to 1_n);
- the second bus connects the output of each of the memory-address output ports (Cadr) and binary output signals (M) for validating the content of each of the first memory sub-units (1_1 to 1_n) of the first set to the input of the unit (4) for selecting maximum likelihood;

and the method comprises:

- providing, as output from the unit (4) for selecting maximum likelihood, input values, and introducing this most represented value (L_i) into the address input port (Adr) of the second memory sub-unit (2).

Fig. 1

Fig. 2

MEin_i ⟶ RSin_1    RSout_1 ⟶ MEout_j

**Fig. 3**

MEin_i    MEout_j

**Fig. 4**

**Fig. 5**

**Fig. 6**

**Fig. 7**

MEin_x

50   51   RSin_1   RSin_2 ------- RSin_n

En → En   E_1   E_2   3   n-1   E_n
Ck →      Sel   S   52

1_1   1_2   1_n

RSi-1   RSi-2   RSi-3   RSi-4 -- RSi-q

In

$RSin\_i\ [w-1:0]=[w-1:a],[a-1:b],[b-1:c],[c-1:d],....[q-1:0]$

-------- , -------- , xxxxxx , -------- ,-- , --------

17

Entrée   Entrée

En ← En   En ← En

Cadr M   Cadr M   Cadr M

/ v / 1   / v / 1   / v / 1

L_1 V_1   L_2 V_2   L_n V_n

| V_1 | L_1 | V_2 | L_2 | V_3 | L_3 | V_4 | L_4 | V_5 | L_5 | V_n | L_n |
|---|---|---|---|---|---|---|---|---|---|---|---|
| 1 | 027 | 1 | 124 | 0 | ------ | 1 | 124 | 1 | 003 | 0 | -------- |
| 1 | 124 | 0 | ----- | | | 1 | 257 | 1 | 257 | | |
| 1 | 542 | | | | | 0 | ----- | 0 | ----- | | |
| 0 | ----- | | | | | | | | | | |

4

| Nb | L_xx |
|---|---|
| 1 | 027 |
| 3 | 124 |
| 1 | 542 |
| 2 | 257 |
| 1 | 003 |

| Max | PosMax |
|---|---|
| 3 | 124 |

42

En ← En
← Ck

L_i

Li=124   Adr   En ← En   2

Sortie → Lout_i

/ v

41   43   Adr

Adr   Adr

Rsout_j $[w-1:0]=[w-1:a],[a-1:b],[b-1:c],[c-1:d],....[p-1:0]$   Sortie   Sortie

1_1   RSo-1   RSo-2   RSo-3   RSo-4 -- RSo-q   1_2   1_n

RSout_1   RSout_2 ------- RSout_n

**Fig. 8**

MEout_y

**Fig. 9**

# Fig. 10

RSout_b1
RSin_b1

RSout_b2
RSin_b2

MEin_b
MEout_b

RSout_b3
RSin_b3

RSout_b4
RSin_b4

10_2

Lin_b

10_3

0

0

Lout_b

60

RSout_a1
RSin_a1

RSout_a2
RSin_a2

MEin_a
MEout_a

RSout_a3
RSin_a3

Lin_a
Lout_a

RSout_a4
RSin_a4

10_1

Lin_c
Lout_c

**Fig. 13**

MA          MB          MC          MD          ME

60_1        ME_a    ME_b          ME_a    ME_b

L_c                      L_c

L_AB                    L_CD                   60_2

60_3        ME_a    ME_b

L_c

L_ABCD

60_4                ME_a    ME_b

**Fig. 14**          L_c

L_ABCDE

Fig. 15

a          Fig. 11          b

a          b          c          d

Fig. 12

**Fig. 16**

**Fig. 17**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 940120882 B
- US 9299430 B1
- US 7709359 B
- FR 2964222 A1
- FR 2980876 A1

**Littérature non-brevet citée dans la description**

- **K. PAGIAMTZIS ; A. SHEIKHOLESLAMI.** Content-addressable memory (CAM) circuits and architectures : A tutorial and survey. *IEEE Journal of Solid-State Circuits,* Mars 2006, vol. 41 (3), 712-727
- **V. GRIPON ; C. BERROU.** Sparse neural networks with large learning diversity. *IEEE trans. on Neural Networks,* Juillet 2011, vol. 22 (7), 1087-1096
- **HOOMAN JAROLLAHI ; VINCENT GRIPON ; NAOYA ONIZAWA ; WARREN J. GROSS.** A low-power Content-Addressable Memory based on clustered-sparse networks. *ASAP, 2013 IEEE 24th int. conférence*
- **F. LEDUC-PRIMEAU ; V. GRIPON ; M. G. RABBAT ; W. J. GROSS.** Clusterbased associative memories built from unreliable storage. *Proc. Of IEEE Intl. Conf. on Acoustics, Speech, and Signal Processing (ICASSP),* Mai 2014
- **DEMETRIO FERRO ; VINCENT GRIPON ; XIAORAN JIANG.** Nearest Neighbour Search Using Binary Neural Networks. *International Joint Conférence on Neural Networks (IJCNN),* 2016
- **QING GUO ; XIAOCHEN GUO ; YUXIN BAI ; ENGIN_LPEK.** A Resistive TCAM Accelerator for Data-Intensive Computing. *MICRO'11,* 03 Décembre 2011
- **QING GUO ; XIAOCHEN GUO ; RAVI PATEL ; ENGIN_LPEK ; EBY G. FRIEDMAN.** AC-DIMM: Associative Computing with STT-MRAM. *ISCA,* 2013
- **P. PIRIM.** Perceptive Invariance and Associative Memory Between Perception and Semantic Représentation, USER a Universal Semantic Représentation Implemented in a System on Chip (SoC). *Living Machines 2016, LNAI,* 2016, vol. 9793, 275-287